# EUROPÄISCHE PATENTSCHRIFT

(11) **EP 1 356 476 B1**
(45) Veröffentlichungstag und Bekanntmachung des Hinweises auf die Patenterteilung: **23.08.2006**
(21) Anmeldenummer: 02719727.6
(22) Anmeldetag: 25.01.2002
(51) Int. Cl.: G21K 1/10

(54) **SCHMALBANDIGER SPEKTRALFILTER UND SEINE VERWENDUNG**
NARROW-BAND SPECTRAL FILTER AND THE USE THEREOF
FILTRE SPECTRAL A BANDE ETROITE ET SON UTILISATION

(30) Priorität: 26.01.2001 DE 10103738; 26.02.2001 DE 10109242; 19.07.2001 DE 10136620
(43) Veröffentlichungstag der Anmeldung: 29.10.2003
(73) Patentinhaber: Carl Zeiss SMT AG, 73447 Oberkochen (DE)
(72) Erfinder: WEDOWSKI, Marco, 73431 Aalen (DE)
(74) Vertreter: Fuchs Mehler Weiss & Fritzsche
(86) Internationale Anmeldenummer: PCT/EP2002/000762
(87) Internationale Veröffentlichungsnummer: WO 2002/059905

(56) Entgegenhaltungen:
- EP-A- 1 150 139
- US-A- 4 870 648
- BARBEE T W JR ET AL: "Molybdenum-silicon multilayer monochromator for the extreme ultraviolet" APPLIED PHYSICS LETTERS, 22 JUNE 1987, USA, Bd. 50, Nr. 25, Seiten 1841-1843, XP002202201 ISSN: 0003-6951
- DATABASE WPI Section Ch, Week 199014 Derwent Publications Ltd., London, GB; Class K08, AN 1990-102918 XP002202202 & JP 02 053002 A (CANON KK), 22. Februar 1990 (1990-02-22)
- DATABASE WPI Section Ch, Week 198808 Derwent Publications Ltd., London, GB; Class A23, AN 1988-052973 XP002202203 & JP 63 008703 A (HOYA CORP), 14. Januar 1988 (1988-01-14)
- VIITANEN V.P. ET AL: 'Fabrication of radiation entrance windows with optimized sub 100 eV transmission properties' JOURNAL OF X-RAY SCIENCE AND TECHNOLOGY Bd. 7, Seiten 130 - 138

## Beschreibung

Die Erfindung betrifft einen optischen Filter für den extrem ultravioletten Wellenlängenbereich und seine Verwendung.

Extrem ultraviolettes Licht (EUV-Licht) wird in Zukunft verstärkt in der Großserienlithographie zur Herstellung von Halbleiterstrukturen und -bauteilen mit Strukturgrößen unterhalb 70 nm verwendet werden. Dazu wird insbesondere Strahlung einer Wellenlänge um 13 nm verwendet werden. Für den Betrieb entsprechender Produktionssysteme werden schmalbandige Spektralfilter mit ausreichender Lebensdauer benötigt werden. Sie sind notwendig, da alle bisher bekannten Quellen extrem ultravioletten Lichts einen sehr geringen Wirkungsgrad haben, der sich zum einen in einer hohen Wärmelast und Debris äußert und zum anderen in einem großen unerwünschten Strahlungsanteil außerhalb des für die Lithographie mit extrem ultraviolettem Licht benötigten Strahlungsbandes. Unter Debris wird dabei jegliches Material, z.B. Keramiken oder Metalle verstanden, das durch den hohen Energieeintrag zur Erzeugung des extrem ultravioletten Lichtes fein zerstäubt wird und sich auf den optischen Elementen und beispielsweise in der Lithographiekammer als Schicht niederschlägt. Durch Verwendung eines Filters als Abtrennung zwischen der Strahlungsquelle und der Lithographievorrichtung kann der Debris aus der Lithographievorrichtung herausgehalten werden, wie dies in WO 00/41875 beschrieben wird. Es muß lediglich das Filter ausgewechselt werden, wenn sich soviel Debris auf dem Filter abgelagert hat, daß die Transmission nicht mehr hinreichend ist.

Optische Filter für den infraroten, den sichtbaren und auch den ultravioletten Wellenlängenbereich sind seit langem bekannt. In der Regel werden dazu transparente Substrate mit einer Schicht versehen, die einen wellenlängenabhängigen Transmissionsgrad aufweist, d.h. bei der die Transmission beginnend bei einer bestimmten Wellenlänge steil ansteigt bzw. steil abfällt. Schichten mit solchen Transmissionskanten werden vielfältig als optische Tiefpaßfilterschichten verwendet, da sie nur Licht ab einer bestimmten Wellenlänge oder innerhalb eines bestimmten Wellenlängenbereiches hindurchlassen.

Gerade für den ultravioletten Wellenlängenbereich sind diverse Filter bekannt, die beispielsweise in Sonnenbrillen oder in Sonnenbänken Verwendung finden.

So ist z.B. aus der EP 0 267 655 A2 ein Filter aus Kunststofffolie mit UVabsorbierenden Pigmenten bekannt, die bei 320 bis 400 nm transparent ist und bei 290 bis 320 nm absorbiert, so daß nur die relativ unschädliche UVA-Strahlung durchgelassen wird.

Aus der US 5,182,670 ist ein Schmalbandfilter für ultraviolettes Licht bekannt, das aus mindestens zwei Al_{X}Ga_{(1-X)}N-Schichten mit unterschiedlichem Aluminiumgehalt und beliebiger Dicke besteht. Durch die Variation des Aluminiumgehaltes ändert sich die Bandlücke dieses Halbleiters und damit die Wellenlänge des transmittierten Lichtes im Bereich von 270 bis 365 nm. Durch die Kombination von mindestens zwei Schichten können beliebige Transmissionen bzw. Reflexionen eingestellt werden.

Bei dem Tiefpaßfilter für den UV-Bereich, der in der US 5,978,134 beschrieben wird, wird die Plasmonenfrequenz von Metall als Grenzfrequenz für die Reflexion genutzt. Dazu werden vor allen Dingen Erdalkali- oder Alkalimetalle eingesetzt. Zusätzlich kann auf dem Tiefpaßfilter ein Interferenzsystem aus MgO oder Al₂O₃ und MgF₂ oder auch Al₂O₃ und SiO₂ aufgebracht sein.

Die DE 44 10 275 A1 offenbart ein Dünnschichtbandpaßfilter für den ultravioletten Wellenlängenbereich, der bei 320 bis 430 nm transparent ist. Die Filterkante wird durch eine Absorptionskante des Materials einer Dünnschicht realisiert und deren spektrale Lage durch Einstellung der Zusammensetzung des Materials der Dünnschicht festgelegt. Dabei ergibt eine Komponente des Materials eine Absorptionskante oberhalb der gewünschten spektralen Lage und die andere Komponente eine Absorptionskante unterhalb der gewünschten spektralen Lage. Bevorzugte Materialien sind Oxide, Fluoride, Sulfide und Oxinitride von Metallen, insbesondere Ta₂O₅, Nb₂O₅, TaO_{X}N_{Y}, HfO_{X}N_{Y}, ZrO_{X}N_{Y}, TiO₂ und ZnS. Ganz besonders bevorzugt werden Nb₂O₅/Ta₂O₅ Einzelschichten einer Dicke zwischen 53,8 nm und 85 nm auf 53 bis 138 nm dicken SiO₂-Schichten. Diese Schichtsysteme weisen Wiederholfaktoren zwischen 1 und 5 auf, um zusätzlich Interferenzeffekte ausnützen zu können.

Aus Viitanen et al, Journal of X-ray science and Technology 7, 130 (1997) sind Niob-Filter für den EUV-Bereich bekannt. Diese haben eine Stützstruktur aus Polyimid. Die US 4 870 648 beschreibt einen Strahlteiler aus abwechselnden Lagen von Mo/Si, mit mindestens 10 Lagen paaren

Im extrem ultravioletten Wellenlängenbereich wird mit reflektierenden Viellagensystemen, insbesondere aus Molybdän- und Siliziumlagen gearbeitet. Diese haben den Nachteil, daß sie in ihrer Herstellung sehr aufwändig und kostenintensiv sind. Daher müssen solche Spiegel zur Verminderung der Strahlungslast und damit der Erhöhung der Lebensdauer gegen unerwünschte spektrale Anteile geschützt werden. Verschärft wird diese Anforderung dadurch, daß die Spiegel Strahlung mit Photenenenergien < 10 eV mit unerwünscht hoher Effizienz reflektieren. Außerdem führt auch die Verunreinigung durch Debris in kürzester Zeit dazu, daß der Spiegel nicht mehr einsetzbar ist. Dadurch werden sehr hohe Kosten und Stillstandzeiten verursacht, die bei einem Einsatz der EUV-Lithographie für die Massenproduktion nicht tragbar sind.

Es ist daher Aufgabe der vorliegenden Erfindung, einen optischen Filter bereitzustellen, der einfach im Aufbau ist und bei Einsatz in EUV-Strahlungsquellen vor weiteren optischen Elementen, wie beispielsweise Spiegeln, ein Wellenlängenband bestimmter Breite vorselektiert. Ferner ist es Aufgabe, Einsatzbereiche für einen derartigen Filter aufzuzeigen.

Diese Aufgabe wird gelöst durch einen optischen Filter für den extremen ultravioletten Wellenlängenbereich, der gekennzeichnet ist durch mindestens zwei Siliziumschichten, zwischen denen mindestens eine Zirkoniumschicht angeordnet ist. Gemäß einer anderen Alternative wird die Aufgabe durch einen Filter gelöst, der gekennzeichnet ist durch mindestens zwei Siliziumschichten, zwischen denen mindestens eine Niob- oder Molybdänschicht angeordnet ist. Außerdem wird die Aufgabe durch Verwendungen gemäß der Ansprüche 25 bis 28 gelöst.

Zur Erreichung einer maximalen Transmission im extrem ultravioletten Wellenlängenbereich, insbesondere in einem Energieband um 92 eV und maximaler Absorption außerhalb dieses Bandes werden die Filtereigenschaften der Materialien Zirkonium und Silizium kombiniert, die beide eine Absorptionskante in der Umgebung von 92 eV aufweisen. Durch die Verwendung von Zirkonium im Filter wird erreicht, daß die Transmission zu kleineren Photonenenergien stark abnimmt. Durch die Verwendung von Silizium im Filter wird erreicht, daß die Transmission dagegen zu höheren Photonenenergien stark abnimmt. Da außerdem das Zirkonium zwischen zwei Siliziumschichten angeordnet ist, wird die Oxidation des Zirkoniums wirksam verhindert, was zu einer höheren Lebensdauer des Filters führt.

Bemerkenswert ist, daß eine relativ schmale spektrale Charakteristik des optischen Filters erreicht wird, obwohl nur die Absorptionseffekte der Filterschichten genutzt werden.

Bisher ist Zirkonium primär als Konstruktionsrohstoff in der chemischen Industrie oder als Legierungsbestandteil in Stahl und Nichteisenmetallen bekannt. Gemäß der US 6,013,399 ist unter anderem Zirkonium als reflektive Schicht Bestandteil einer Maske für die EUV-Lithographie. Firmenintemer Stand der Technik war bisher, daß der Einsatz von Zirkonium in transmittierenden optischen Elementen für den EUV-Bereich einerseits an der schnellen Oxidation des Zirkoniums sowie an der benötigten geringen Dicke scheitern muß. In einem optischen Kontext ist eher ZrO₂ als Dielektrikum in Interferenzsystemen (s. DE 44 10 275 A1) oder Zirkoniumphosphat beispielsweise in Phosphoreszenzschirmen für Röntgenstrahlung, wie beispielsweise in der EP 0 860 492 A1 beschrieben, bekannt. ZrO₂ wird auch als Schutzschicht gegen die Oxidation von Substraten eingesetzt (s.z.B. EP 0 588 038 B1).

Nach der Filterung der Eingangsstrahlung, z.B. der Strahlung einer Synchrotronstrahlungsquelle durch den erfindungsgemäßen Filter steht schmalbandige Strahlung mit hoher Intensität zur Verfügung. Zugunsten höherer Intensität ist die Bandbreite zwar höher als der Bandpaß der nachfolgend angeordneten optischen Elemente, wie z.B. Mo/Si-Spiegel, es findet aber bereits eine Einengung auf den extrem ultravioletten Spektralbereich statt. Insbesondere sind die Anteile im Sichtbaren (VIS), im Ultravioletten (UV) und Tiefultravioletten (DUV) auf nahe Null reduziert.

Der erfindungsgemäße Filter kann auch als Schutz vor Debris eingesetzt werden. Dazu sollte der erfindungsgemäße Filter z.B. als Abschluß der EUV-Strahlungsquelle angeordnet werden, so daß jeglicher Debris aufgehalten wird und verhindert wird, daß der Debris sich auf den nachfolgenden optischen Elementen ablagert.

Vorzugsweise sind die Siliziumschichten dicker als die Zirkoniumschicht. Diese Ausführungsform hat den Vorteil, daß die Photonen zu höheren Energien hin in vergleichbarem Maße wie zu niedrigen Energien hin absorbiert werden.

Vorzugsweise liegt die Dicke der Zirkoniumschicht im Bereich von 1 nm bis 1000 nm, besonders bevorzugt im Bereich von 5 nm bis 100 nm.

Vorteilhafterweise hält man bei der Wahl der Schichtdicken des Zirkoniums und des Siliziums folgende Beziehung ein: $d Si = 1 - {e}^{- k . d Zr}$
mit
- dSi: Siliziumschichtdicke (in µm)
- dZr: Zirkoniumschichtdicke (in nm)
und
0,001 ≤ k ≤ 0,005 (in 1/nm).

Die für die Anwendung in der EUV-Lithographie besten Ergebnisse sowohl hinsichtlich des Transmissionsverlaufes als auch der mechanischen Stabilität wurden mit Siliziumschichten einer Dicke zwischen 50 und 100 nm, bevorzugt 70 und 90 nm sowie einer Zirkoniumschichtdicke zwischen 10 bis 40 nm, bevorzugt 20 und 30 nm erreicht.

Für Strahlungsquellen ausgesprochen hoher Brillianz, wie z.B. Synchrotronstahlungsquellen, kann es aber auch notwendig sein, Filter einzusetzen, deren Zirkoniumschicht eine Dicke von einigen 100 nm und deren Siliziumschichten Dicken von mehreren 100 nm aufweisen, vorzugsweise Si 700-900 nm, Zr 400-600 nm, insbesondere 800 nm Si/500 nm Zr/800 nm Si für einen Filter mit ca. 1 % Transmission.

Zur Erreichung einer maximalen Transmission im extrem ultravioletten Wellenlängenbereich, insbesondere in einem Energieband um 92 eV und maximaler Absorption außerhalb dieses Bandes werden die Filtereigenschaften der Materialien Niob oder Molybdän und Silizium kombiniert. Durch die Verwendung von Niob oder Molybdän im Filter wird erreicht, daß die Transmission zu kleineren Photonenenergien stark abnimmt. Durch die Verwendung von Silizium im Filter wird erreicht, daß die Transmission dagegen zu höheren Photonenenergien stark abnimmt.

Vorzugsweise liegt die Dicke der Niob- oder Molybdänschicht im Bereich von 1 nm bis 1000 nm, besonders bevorzugt im Bereich von 5 nm bis 100 nm.

Vorteilhafterweise hält man bei der Wahl der Schichtdicken des Niob und des Siliziums folgende Beziehung ein: $d Si = 1 - {e}^{- k . d Nb}$
mit
- dSi: Siliziumschichtdicke (in µm)
- dNb: Niobschichtdicke (in nm)
und
0,001 < k < 0,005 (in 1/nm)
bzw. für Molybdän und Silizium: $d Si = 1 - {e}^{- k . d Mo}$
mit
- dSi: Siliziumschichtdicke (in µm)
- dMo: Molybdänschichtdicke (in nm)
und
0,001 < k < 0,005 (in 1/nm).

Die Siliziumschichten sind vorzugsweise dicker als die Niob- oder Molybdänschicht, damit die Photonen zu höheren Energien hin in vergleichbarem Maße wie zu niedrigen Energien hin absorbiert werden. Da außerdem Niob oder das Molybdän zwischen zwei Siliziumschichten angeordnet ist, wird die Oxidation des Niobs oder Molybdäns wirksam verhindert, was zu einer höheren Lebensdauer des Filters führt.

Die für die Anwendung in der EUV-Lithographie besten Ergebnisse sowohl hinsichtlich des Transmissionsverlaufes als auch der mechanischen Stabilität wurden mit Siliziumschichten einer Dicke zwischen 50 und 100 nm, bevorzugt 70 und 90 nm, sowie einer Niob- oder Molybdänschichtdicke zwischen 10 bis 40 nm, bevorzugt 20 und 30nm, erreicht.

Für Strahlungsquellen ausgesprochen hoher Brillianz, wie z.B. Synchrotronsstrahlungsquellen, kann es aber auch notwendig sein, Filter einzusetzen, deren Niob- oder Molybdänschicht eine Dicke von einigen 100 nm und deren Siliziumschichten Dicken von mehreren 100 nm aufweisen, z.B. 700-900 nm (Si)/400-600 nm (Nb oder Mo)/700-900 nm (Si), insbesondere 800 nm (Si)/500 nm (Nb oder Mo)/800 nm (Si) für einen Filter mit 1 % Transmission.

In einer bevorzugten Ausführungsform sind die mindestens drei Schichten selbsttragend. Es hat sich herausgestellt, daß bei den meisten Dicken- zu Breitenverhältnissen der erfindungsgemäße optische Filter durch die mindestens drei Schichten eine hinreichende mechanische Stabilität erhält, so daß maximale Abmessungen in der Filterebene, z.B. Durchmesser, zwischen 1 cm und 4 cm möglich sind.

Für besondere Anwendungen hat es sich aber als vorteilhaft erwiesen, wenn die mindestens drei Schichten auf einer Stützstruktur aufgebracht sind. Dies ist insbesondere wichtig, wenn der Filter außergewöhnlichen mechanischen Belastungen ausgesetzt ist oder Filter mit z.B. großen Durchmessern bzw. Breiten/Längen verlangt werden, bei denen die Erhöhung der Schichtdicken bei vergleichbarer mechanischer Stabilität zu einer höheren Transmissionsverminderung führen würde als durch eine Stützstruktur verursacht wird. Besonders bewährt haben sich als Stützstrukturen netzförmige Strukturen z.B. aus Nickel. Bei Filtern mit Stützstruktur können maximale Abmessungen in der Ebene zwischen 8 cm und 14 cm erreicht werden. Der optische Filter kann als Ganzes auf der Stützstruktur aufgebracht sein. Die Stützstruktur kann aber auch zwischen zwei Schichten des optischen Filters angeordnet sein.

Es kann von Vorteil sein, wenn der optische Filter auf mindestens einer Seite mindestens eine weitere Schicht aufweist, die Schutzfunktion hat, ohne wesentlichen Einfluß auf die maximale Transmission des optischen Filters zu haben. Gleichzeitig kann aber eine spektrale Einengung erreicht werden. Diese Schutzschichten können sich z.B. durch Ablagerungen von insbesondere Kohlenstoff und Sauerstoff aus der Atmosphäre bilden und die Lebensdauer des optischen Filters verlängern. Die Schutzschichten können auch gezielt auf dem optischen Filter aufgebracht sein. Dabei sind Schichtdicken zwischen 0,1 nm und 100 nm, insbesondere 1 nm bis 50 nm zu empfehlen. Es besteht die Möglichkeit, alle bekannten Methoden der Vermeidung von Kontamination von Siliziumschichten auch an dem optischen Filter anzuwenden. Dadurch sind Lebensdauern von > 10 000 h zu erwarten.

Besonders bevorzugt werden optische Filter, die auf mindestens einer Seite des Filters eine Rutheniumschicht oder eine Rhodiumschicht aufweisen. Vorteilhafterweise weisen diese Schichten eine Dicke zwischen 0,1 nm bis 100 nm, insbesondere 1 nm bis 50 nm, vorzugsweise 1 nm bis 20 nm, auf. Durch diese Schutzschichten wird nicht nur die mechanische Stabilität des Filters erhöht, sondern auch die Lebensdauer des Filters bei Bestrahlung mit insbesondere extrem ultravioletter Strahlung erhöht, da insbesondere die Oxidation durch Sauerstoff unterbunden wird. Sowohl die Ruthenium- als auch die Rhodiumschichten wirken sich außerdem auf die spektrale Charakteristik des Filters aus, indem durch sie der spektrale Bereich zwischen ca. 50 eV und 80 eV unterdrückt wird. Dies führt zu einer schmaleren spektralen Charakteristik des Filters mit einer geringen Einbuße an maximaler Transmission des Filters (ca. 10 %).

Es hat sich auch als vorteilhaft herausgestellt, wenn der Filter auf mindestens einer Seite eine Schutzschicht, die Bor, Kohlenstoff, Stickstoff und/oder Sauerstoff enthält, oder deren Verbindungen, wie Kohlenwasserstoffe, Oxide, Karbide, Nitride, Boride, SiC, BN, BCN, B₄C etc., aufweist, was nachfolgend als "BCNO" abgekürzt wird. Vorzugsweise hat sie eine Dicke zwischen 0,1 nm bis 100 nm, besonders bevorzugt zwischen 1 nm und 50 nm. Sie kann gezielt während der Herstellung des optischen Filters beispielsweise als äußerste Schicht aufgebracht werden. Die mindestens eine Schutzschicht erhöht sowohl die mechanische und thermische Stabilität als auch die Lebensdauer des Filters und verhindert die Oxidation der Filteroberflächen durch Sauerstoff aus der Atmosphäre.

Ob der Filter nur auf einer oder auf beiden Seiten eine Ruthenium-, Rhodium- oder "BCNO"-Schicht aufweist, entscheidet sich danach, in welcher Umgebung der Filter eingesetzt wird und welchen Einflüssen die jeweilige Seite ausgesetzt ist.

Es hat sich als vorteilhaft erwiesen, zwischen einer solchen außenliegenden Schicht, insbesondere zwischen der Ruthenium- oder Rhodiumschicht und der Siliziumschicht eine Diffusionsbarriere-Schicht vorzusehen. Diese Diffusionsbarriere-Schicht enthält vorzugsweise Bor, Kohlenstoff, Stickstoff und/oder Sauerstoff in einer Verbindung einzeln oder in Kombination. Besonders bevorzugt besteht diese Schicht aus "BCNO", insbesondere aus Siliziumkarbid (SiC), Bornitrid (BN), Borcarbonitrid (BCN) oder Borkarbid (B₄C). Diese Diffusionsbarriere dient dazu, die Diffusion des Siliziums insbesondere in die Ruthenium- bzw. Rhodiumschicht zu verhindern, die dort zu einer Ruthenium- bzw. Rhodium-Siliziumlegierung verändert wird, wodurch die Filtereigenschaften und die Lebensdauer des optischen Filters beeinträchtigt werden könnten. Da die vorgeschlagenen Diffusionsbarrieren-Materialien im extrem ultravioletten Wellenlängenbereich nicht nennenswert absorbieren, ist ihre Wirkung auf die spektrale Charakteristik des Filters vernachlässigbar.

Die Materialien Stickstoff und Sauerstoff können dadurch aufgebracht werden, daß der Filter vor dem Aufbringen der Schutzschicht über eine vorgegebene Zeit einem entsprechenden Gas, beispielsweise einer Stickstoff-Sauerstoffatmosphäre, ausgesetzt wird.

Wenn die Siliziumschicht kurzzeitig an die Atmosphäre gebracht wird, bildet sich eine Siliziumdioxidschicht aus, deren Dicke maximal 1,5 nm beträgt. Über die Zeitdauer, die die Siliziumschicht der Atmosphäre ausgesetzt wird, kann die Dicke im Bereich zwischen 0,1 und 1,5 nm, bevorzugt zwischen 0,5 nm und 1 nm, eingestellt werden. Der Vorteil der Siliziumoxidschicht besteht darin, daß die Herstellung im Vergleich zu dem Aufbringen anderer Materialien deutlich vereinfacht und kostengünstiger ist.

Vorzugsweise weisen die Diffusionsbarrieren eine Dicke zwischen 0,1 nm bis 50 nm, vorzugsweise 1 nm bis 10 nm, auf. Dadurch wird auch die mechanische Stabilität des Filters weiter erhöht. Durch eine Gasfüllung der Umgebung der optischen EUV-Komponenten, insbesondere mit Ar, ist eine weitere Verbesserung der Filterwirkung der erfindungsgemäßen Filter möglich. Der Fülldruck liegt vorzugsweise bei 0,1 bis 10⁻⁸ mbar.

Als allgemeine Schichtfolge ergibt sich (mit Alternativen in runden Klammern): (Ru, Rh)/Si/(Zr, Nb, Mo)/Si/(Ru, Rh)/(mit "BCNO" als Schutzschicht und/oder Diffusionsbarriere an den Grenzflächen). Ein solcher Filter kann sich in einem Gas, vorzugsweise in einem Ar-Gas befinden, das an der Filterung teilnimmt, so daß auch von einer Gas-, insbesondere (Ar)-Schicht gesprochen werden kann. Je nach Anwendung können einzelne oder auch mehrere der genannten Komponenten wegfallen oder können auch vertauscht werden. Optimale Filterwirkung und Lebensdauer wird aber besonders durch die geeignete Kombination möglichst vieler Komponenten in obiger Reihenfolge erreicht.

Die Erfindung bezieht sich auch auf eine optische Vorrichtung mit einem Strahlengang für den EUV-Wellenlängenbereich, insbesondere auf ein Lithographiegerät für die Halbleiterbauteilproduktion, wobei der Strahlengang mindestens einen erfindungsgemäßen Filter aufweist. Um die Filterwirkung eines Gases ausnutzen zu können, ist die Vorrichtung derart ausgebildet, daß sie mit einer definierten Gasatmosphäre bei einem definierten Druck betrieben werden kann. Vorzugsweise befindet sich mindestens der Filter innerhalb der Vorrichtung in einer Gas-, vorzugsweise Ar-Atmosphäre mit einem Druck von 10⁻² - 10⁻⁸ mbar. Bevorzugte Drücke sind 10⁻³ - 10⁻⁷ mbar und insbesondere 10⁻⁵ mbar.

Vorzugsweise läßt sich der erfindungsgemäße Filter in Beleuchtungssystemen oder auch Projektionsbelichtungsanlagen für EUV-Licht, insbesondere zur Lithographie für die Halbleiterbauteilproduktion einsetzen. Dabei kann es sich um herkömmliche Systeme, aber auch um neuwertige Systeme handeln, wie sie z.B. für das Belichtungssystem in der DE 199 48 240.3 oder z.B. für das Projektionssystem in der DE 101 00 265.3 beschrieben sind. Der optische Filter wird vorteilhafterweise an Positionen mit geringem Strahlquerschnitt aber außerhalb von Strahltaillen und Brennpunkten angeordnet. Vorzugsweise dient er neben der spektralen Einengung des Strahls zur vakuumtechnischen Trennung der EUV-Quelle und der Beleuchtungsoptik oder auch der Projektionsoptik und des resistbeschichteten Wafers. Der Einsatz des Filters ist außer in Lithographiegeräten zur Großserienproduktion von Halbleiterelementen auch möglich in EUV-Meßgeräten, die fest an Lithographiegeräten installiert sind oder als mobile Einheit für allgemeine Tests an EUV-Geräten zur Verfügung stehen. Ein Einsatz in stationären Einheiten für Komponententests von optischen EUV-Komponenten ist ebenso möglich wie in EUV-Entwicklungs- und/oder Demonstrationsgeräten zur Prozeßentwicklung.

Da der erfindungsgemäße Filter aus leicht verfügbaren und relativ preiswerten Materialien besteht und ohne großen Aufwand mit üblichen Beschichtungstechniken hergestellt werden kann, da keine besonderen Fertigungstoleranzen einzuhalten sind, ist er für die Anwendung in der Großserienlithographie geeignet.

Nachfolgend wird die Erfindung anhand von Ausführungsbeispielen näher erläutert. Es zeigen
- Fign. 1a-c: die spektralen Charakteristika der Einzelschichten und der daraus zusammengesetzten Filter;
- Fign. 2a-d: die spektralen Charakteristika von Filtern ohne Stützstruktur und mit Stützstruktur;
- Fign. 3a,b: die Wirkung verschiedener Filter bei Anordnung an einer Synchronotronstrahlungsquelle;
- Fign. 4a-c: den Aufbau verschiedener Filter;
- Fign. 5a-d: die spektralen Charakteristika der Einzelschichten und der daraus zusammengesetzten Filter;
- Fign. 6a,b: den Aufbau verschiedener Filter;
- Fig. 7: ein optisches System mit Filter; und
- Fign. 8a-d: die spektralen Charakteristika der Einzelschichten und der daraus zusammengesetzten Filter.

Es wurde ein erster Testfilter hergestellt, der aus einer 30 nm dicken Zirkoniumschicht besteht, die zwischen je 80 nm dicken Siliziumschichten angeordnet ist. Beim Kontakt mit der Atmospäre lagern sich auf beiden Filterseiten ca. 1,5 nm dicke Oxidschichten sowie 0,5 nm dicke Kohlenstoffschichten ab, wobei der Sauerstoff mit dem Silizium zu Siliziumoxid reagiert hat. Da die Zirkoniumschicht von den Siliziumschichten eingeschlossen ist, wird sie von angreifendem Sauerstoff nicht oxidiert. Der Filter hat einen Durchmesser von 10 mm und ist mechanisch so stabil, daß mehrere Transporte per Post und die mehrfache Handhabung in verschiedenen Laboren schadlos überstanden wurden.

Es wurde auch ein zweiter Testfilter hergestellt, der zusätzlich zu den Silizium- und Zirkoniumschichten des ersten Testfilters auf den Außenseiten beider Siliziumschichten jeweils eine Rhodiumschicht einer Dicke von 5 nm aufweist. Bei Kontakt mit der Atmosphäre lagern sich wegen der geringen Oxidation von Rhodium auf beiden Seiten lediglich kohlenstoffhaltige Schichten einer Dicke von etwa 0,5 nm ab.

Da Untersuchungen gezeigt haben, daß die optischen Eigenschaften von Rhodium und Ruthenium im extrem ultravioletten Wellenlängenbereich, insbesondere um 92 eV sehr ähnlich sind, wurde stellvertretend ein Testfilter mit Rhodiumschichten gewählt. Die diesbezüglichen Ausführungen gelten auch für Filter mit Rutheniumschichten.

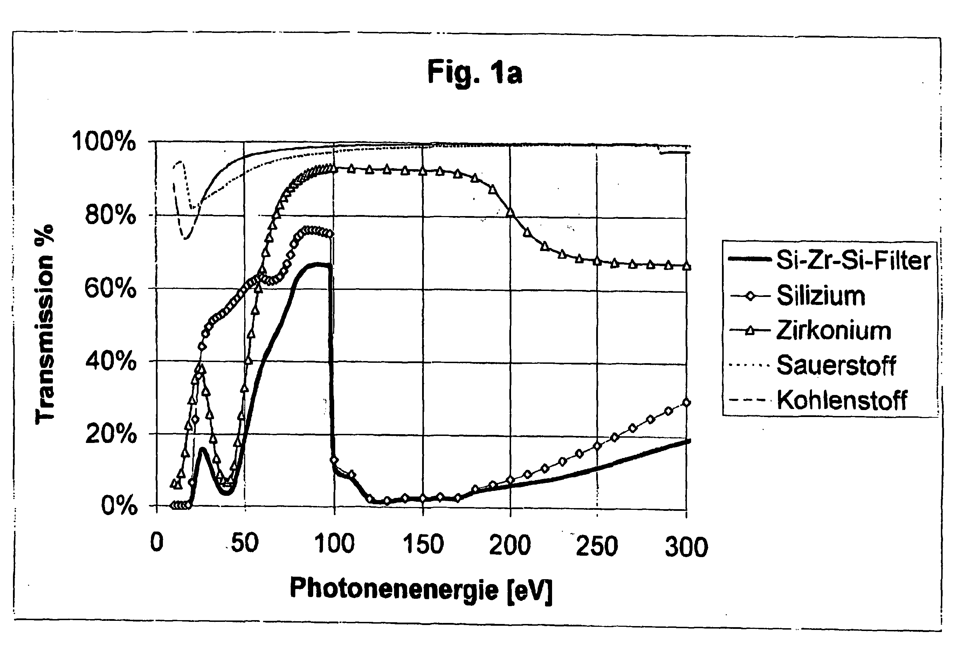

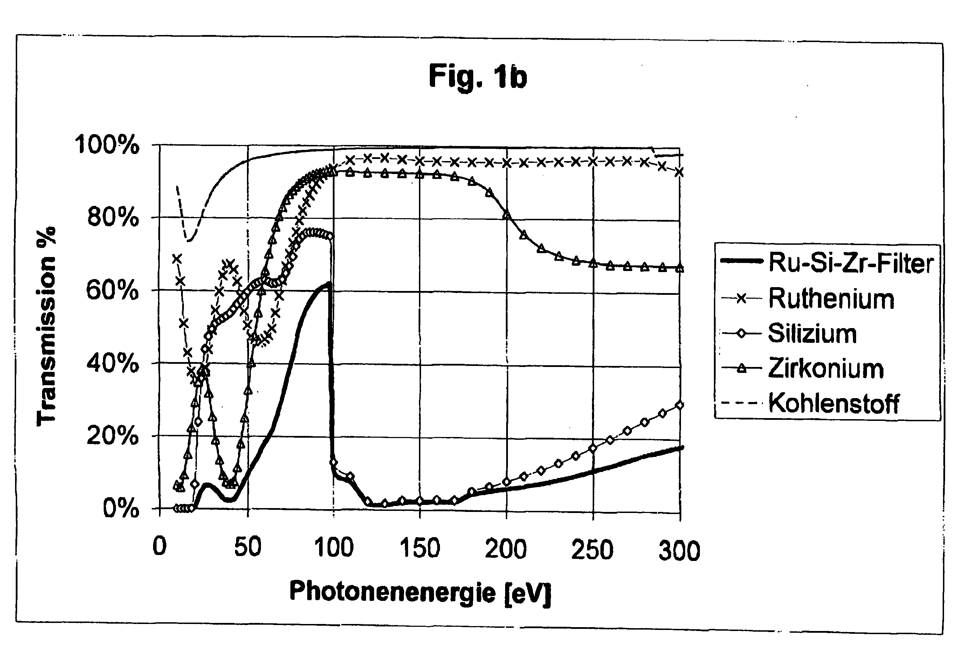

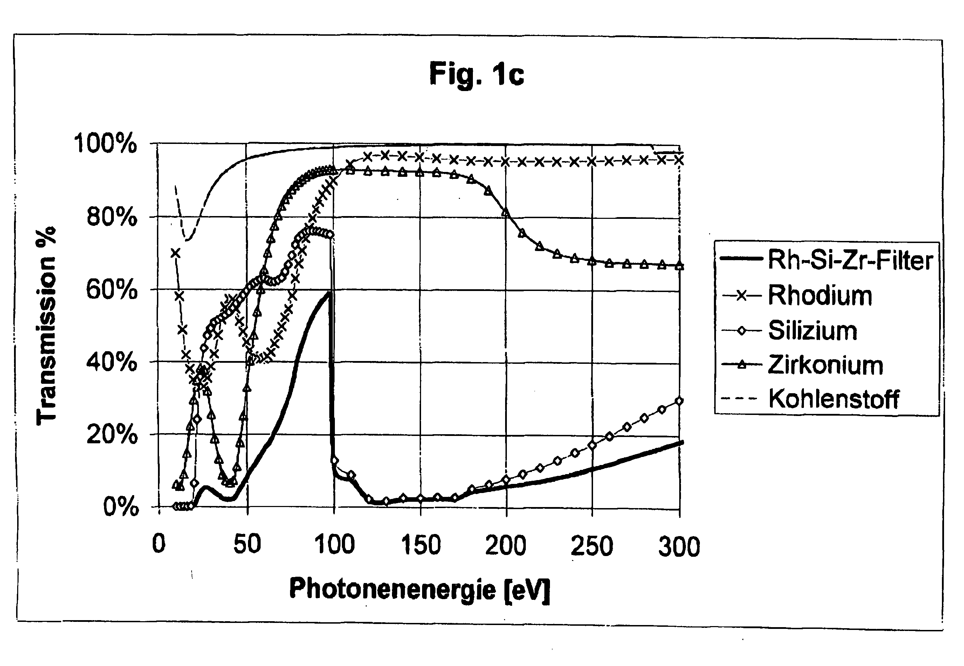

In Figur 1a ist die spektrale Charakteristik der Einzelmaterialien Silizium, Zirkonium, Sauerstoff und Kohlenstoff in den oben angegebenen Dicken gezeigt. Außerdem ist die spektrale Charakteristik des sich daraus ergebenden Filters (Si-Zr-Si) dargestellt. Wie in Figur 1 zu erkennen ist, nimmt die Transmission von Zirkonium ab ca. 70 eV zu kleineren Photonenenergien hin stark ab. Die Transmission von Silizium nimmt dagegen von 92 eV zu höheren Photonenenergien hin stark ab. Die Transmission der Sauerstoffschicht ist in dem relevanten Bereich um 92 eV (entspricht 13 nm) annähernd konstant. Daß der Sauerstoff das Silizium oxidiert, hat auf die Transmission keinen Einfluß; es kommt lediglich auf die Anzahl der vorhandenen Atome an. Die Transmission der Kohlenstoffschicht ist in erster Näherung konstant gleich 1. Der spektrale Einfluß sowohl der dünnen, natürlichen Oxid- als auch Kohlenstoffschicht ist also sehr gering. Diese Schichten wirken sich aber positiv auf die Lebensdauer des optischen Filters sowohl in der Atmosphäre als auch im Vakuum unter EUV-Bestrahlung aus. Der Filter führt dazu, daß für das Energieband um 92 eV eine Transmission von mehr als 60 % vorhanden ist. Unterhalb von 50 eV und oberhalb von 100 eV liegt die Transmission deutlich unter 10 %. Erst oberhalb von 250 eV steigt die Transmission wieder auf über 10 % an. Da aber keine der heute bekannten Quellen, die für die Verwendung als Lichtquelle für die EUV-Lithographie in Frage kommen, in diesem Energiebereich nennenswerte Flüsse aufweist, ist dies von untergeordneter Bedeutung.

In Figur 1b ist statt der spektralen Charakteristik von Sauerstoff die von Ruthenium aufgetragen und außerdem die spektrale Charakteristik des sich daraus ergebenden Filters (Ru-Si-Zr-Si-Ru). Wegen der geringen Oxidation des Rutheniums bilden sich auf den Filteroberflächen nur kohlenstoffhaltige Schichten. Um den Preis einer reduzierten Transmission, die im Maximum etwa 55 % beträgt, erhält man eine schmälere spektrale Charakteristik. Die Transmission im Bereich zwischen 50 eV und 80 eV ist gegenüber dem ersten Testfilter deutlich reduziert.

Die Figur 1c zeigt ein entsprechendes Diagramm für einen Filter des Schichtsystems Rh-Si-Zr-Si-Rh.

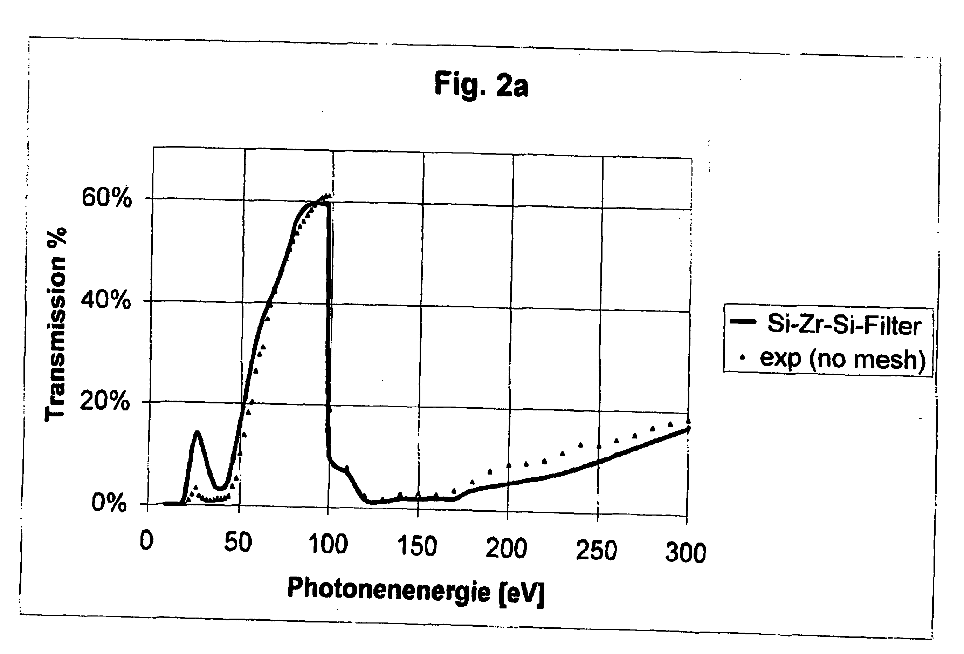

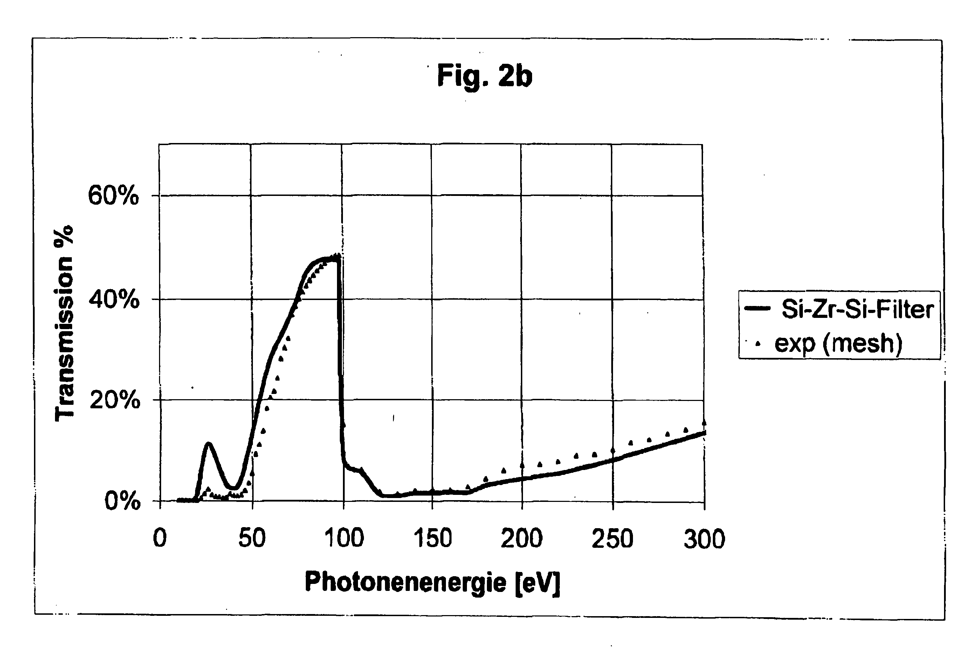

In Figur 2a,2b sind die spektralen Charakteristika für Filter (Si-Zr-Si) ohne Stützstruktur und Filter (Si-Zr-Si) mit Stützstruktur dargestellt. Dabei werden auch die theoretisch berechneten Werte mit experimentell gemessenen Werten verglichen. Bei der Stützstruktur handelt es sich um eine netzförmige Stützstruktur aus Nickel, deren Netzweite 70 Linien/Zoll entspricht. Die Erhöhung der mechanischen und thermischen Stabilität, die durch die netzförmige Stützstruktur erreicht wird, geht mit einem Verlust von 20 % der Transmission gegenüber Filtern ohne Stützstruktur einher.

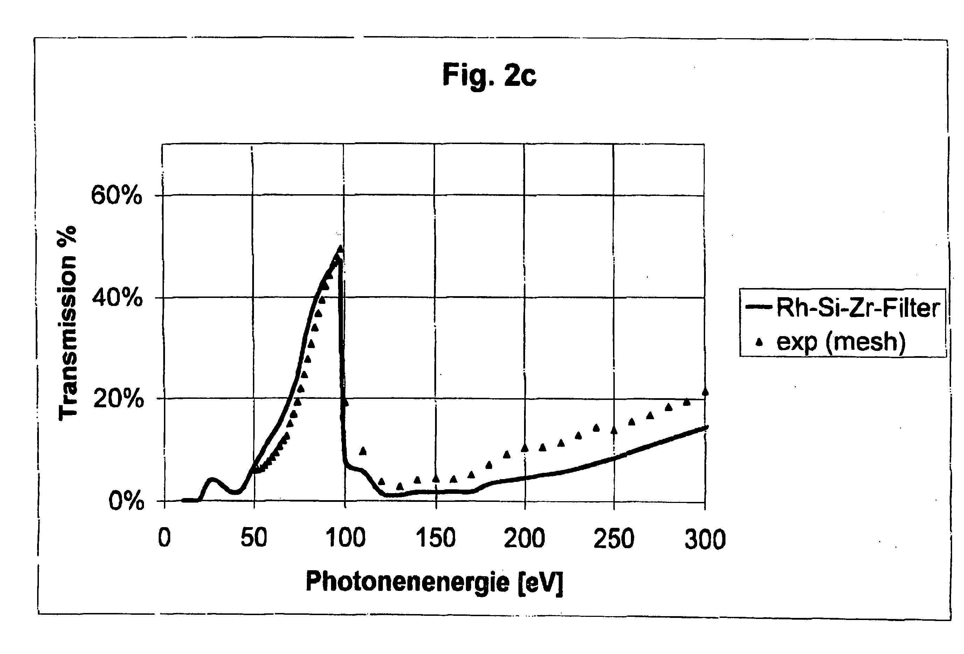

Zum Vergleich ist in Figur 2c die spektrale Chrakteristik eines Filters mit Netz und mit Rhodiumbeschichtung zur Vermeidung der Oxidation an der Oberfläche dargestellt. Die Schichtenfolge dieses Filters ist wie folgt: Rh-Si-Zr-Si-Rh.

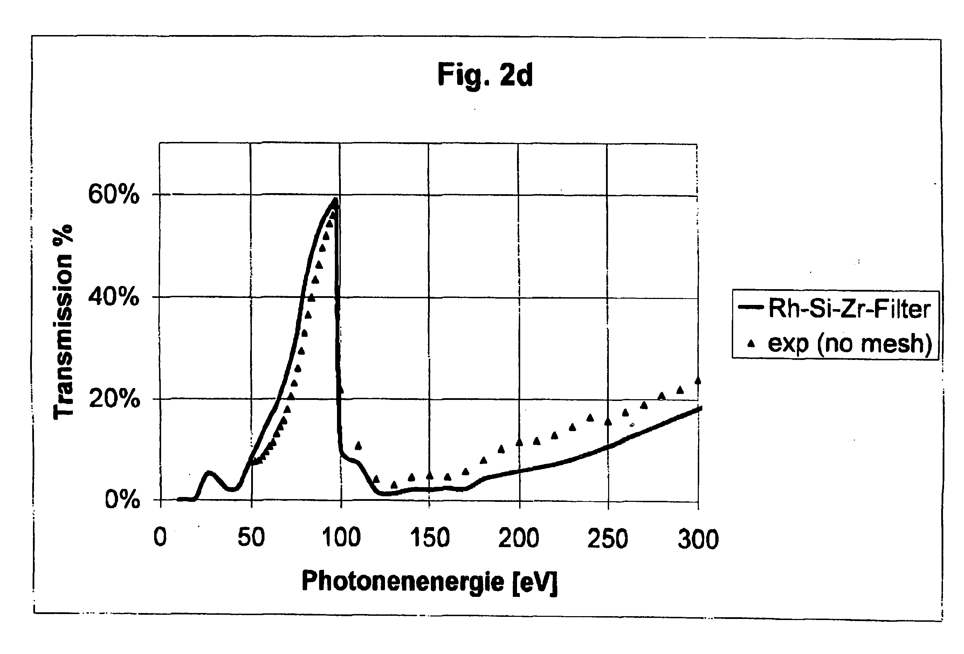

Die Figur 2d zeigt das entsprechende Diagramm eines Filters mit Schichtaufbau Rh-Si-Zr-Si-Rh ohne Netzstruktur.

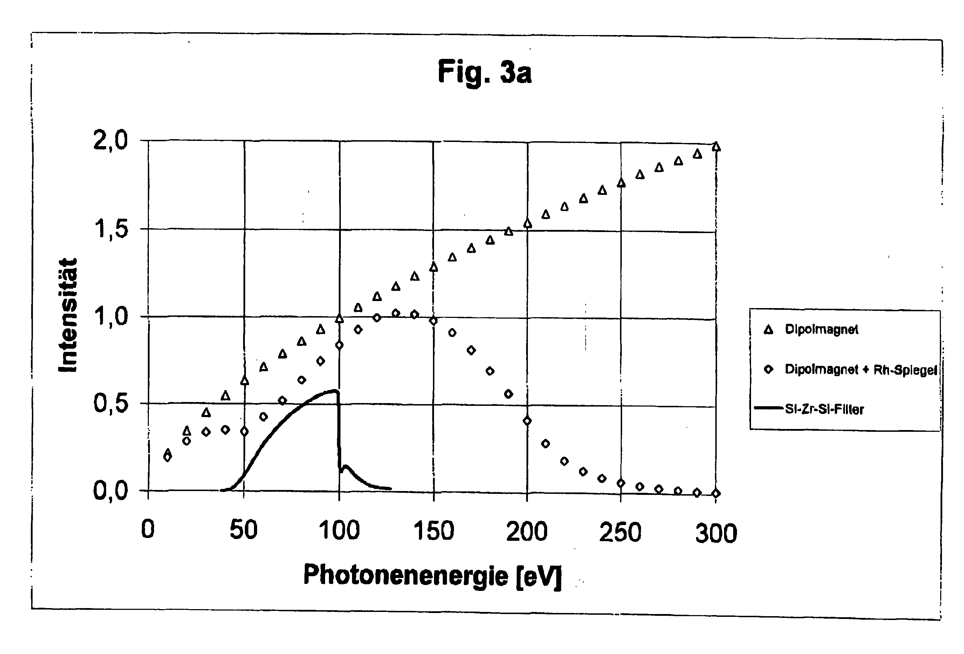

In Figur 3a ist zum einen die spektrale Charakteristik der Strahlung eines Dipolmagneten an der Elektronenspeicherringanlage BESSY II sowie die spektrale Charakteristik der Strahlung des Dipolmagneten nach Reflexion an einem Rhodium-beschichteten Spiegel unter einem Ablenkwinkel von 10° dargestellt. Die aufgetragene Intensität wurde auf die maximale Intensität der Strahlung des Dipolmagneten nach Reflexion an dem Rhodium-beschichteten Spiegel normiert. Ordnet man hinter einem Dipolmagneten und einem Rhodiumspiegel einen wie oben beschriebenen Filter (Si-Zr-Si) an, erhält man ein Intensitätsmaximum bei ca. 92 eV mit einer Halbwertsbreite von ca. 35 eV.

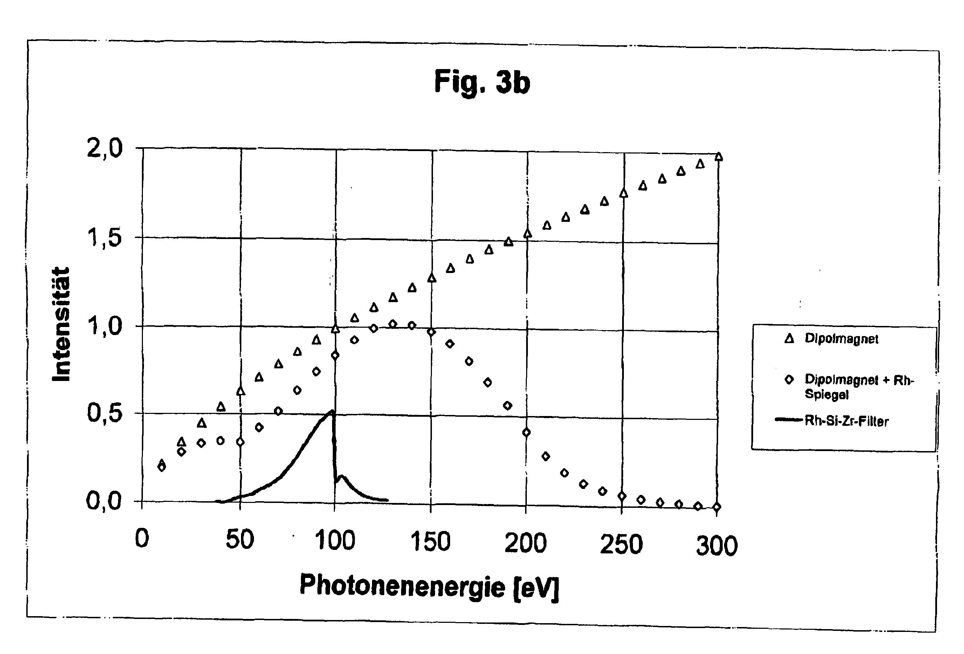

In Figur 3b ist statt der spektralen Charakteristik des ersten Testfilters die spektrale Charakteristik des zweiten Testfilters (Rh-Si-Zr-Si-Rh) dargestellt. Die Halbwertsbreite beträgt in diesem Falle nur noch ca. 20 eV. Die Strahlung hinter den Testfiltern eignet sich sehr gut als Eingangsstrahlung für die optischen Elemente eines EUV-Lithographiesystems.

Bei einem Lebensdauertest führte eine EUV-Bestrahlung mit 1 W/cm² über 200 Stunden in einem Vakuum von 10⁻⁸ mbar bei beiden Filtern zu keiner meßbaren Veränderung. Bei Lagerung in der Atmosphäre war über zwölf Monate keine Veränderung der Transmissionseigenschaften feststellbar.

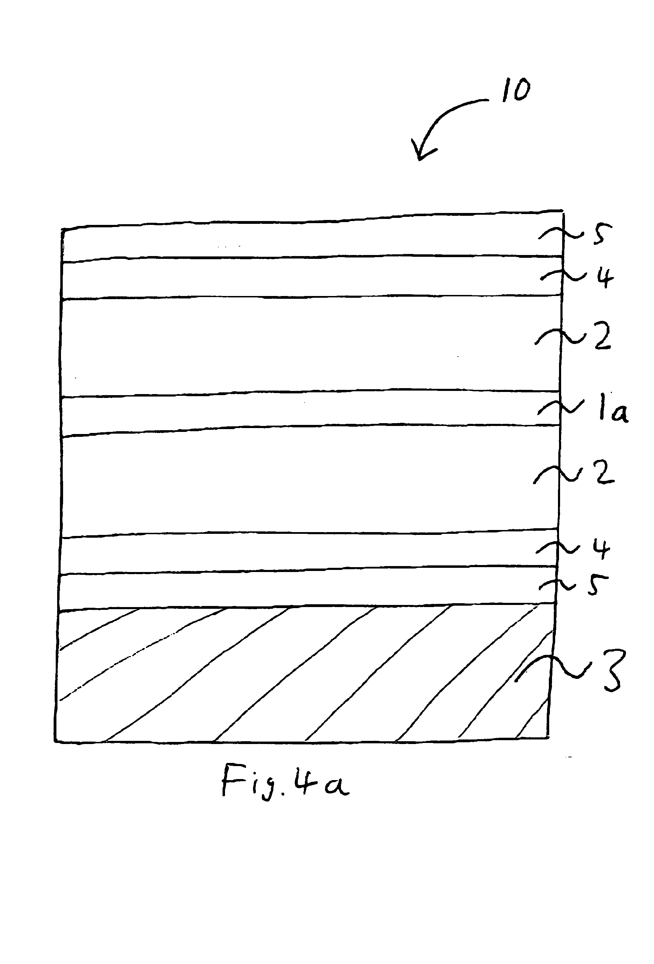

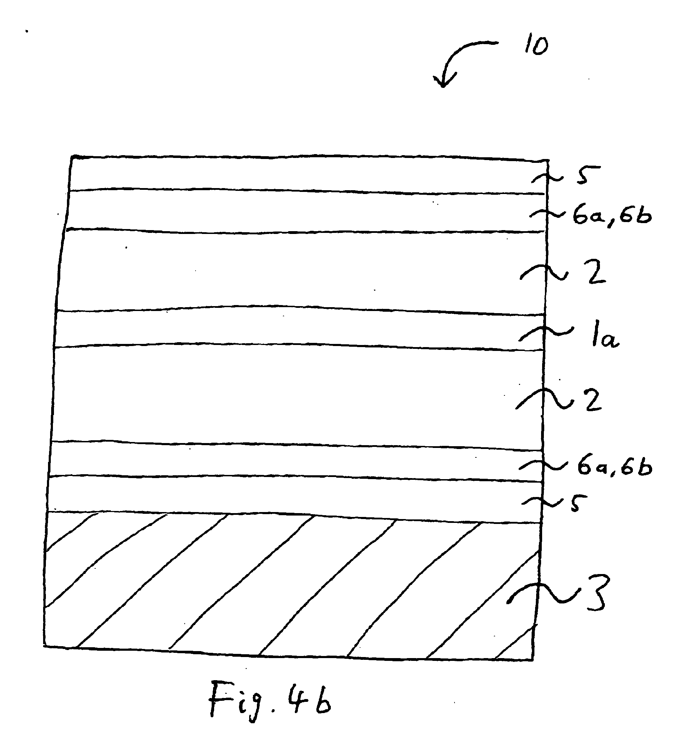

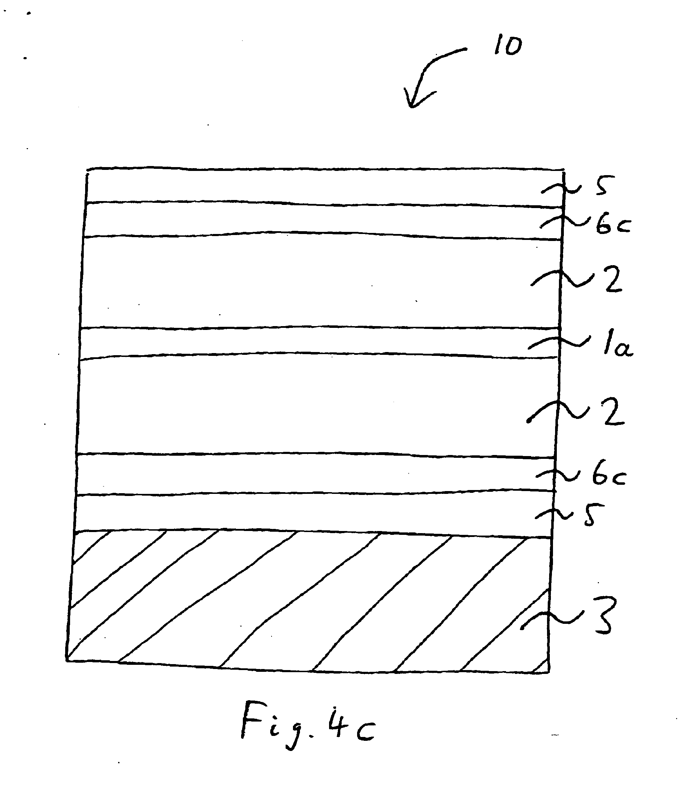

In Figur 4a ist der schematische Aufbau eines Filters 10 dargestellt. Auf beiden Seiten einer 10 bis 40 nm dicken Zirkoniumschicht 1a sind 50 nm bis 100 nm dicke Siliziumschichten 2 angeordnet. Auf beiden Seiten haben sich 1 nm bis 2 nm dicke Oxidschichten 4 und 0,5 nm bis 1,5 nm dicke kohlenstoffhaltige Schichten 5 abgelagert, die auf das Transmissionsverhalten des Filters 10 keinen entscheidenden Einfluß haben. Zur mechanischen und thermischen Stabilisierung ist das Gesamtsystem auf einem Nickelnetz 3 angeordnet.

In Figur 4b ist der Aufbau eines weiteren Filters 10 dargestellt. Die Zirkoniumschicht la und die beiden Siliziumschichten 2 weisen auf beiden Seiten des Filters 10 jeweils eine 0,1 nm bis 50 nm (vorzugsweise 1 nm bis 20 nm, insbesondere 5 nm) dicke Rutheniumschicht 6a oder Rhodiumschicht 6b auf, auf die sich an der Atmosphäre eine 0,5 nm bis 1,5 nm, insbesondere 1 nm, dicke kohlenstoffhaltige Schicht 5 ablagert. Fakultativ können zwischen den Schichten 6a oder 6b und den Siliziumschichten 2 Diffusionsbarrieren, die Bor, Kohlenstoff, Stickstoff und/oder Sauerstoff enthalten, mit einer Dicke zwischen 0,1 nm bis 50 nm (vorzugsweise 0,1 nm bis 10 nm, insbesondere 2 nm) vorgesehen werden. Durch die Rutheniumschichten 6a oder Rhodiumschichten 6b werden nicht nur die mechanische Stabilität und die Lebensdauer erhöht, sondern auch die spektrale Charakteristik des Filters 10 geschmälert.

Zur mechanischen und thermischen Stabilisierung ist das Gesamtsystem auf einem Nickelnetz 3 angeordnet.

Statt einer Rutheniumschicht 6a oder Rhodiumschicht 6b könnte während des Herstellungsprozesses auch direkt auf die Siliziumschichten 2 eine Schicht 6c, die Bor, Kohlenstoff, Stickstoff und/oder Sauerstoff enthält, mit einer Dicke zwischen 0,1 nm und 50 nm aufgebracht werden, auf die sich gegebenenfalls an der Atmosphäre eine weitere kohlenstoffhaltige Schicht 5 von 0,5 - 1,5 nm Dicke ablagern würde (s. Figur 4c).

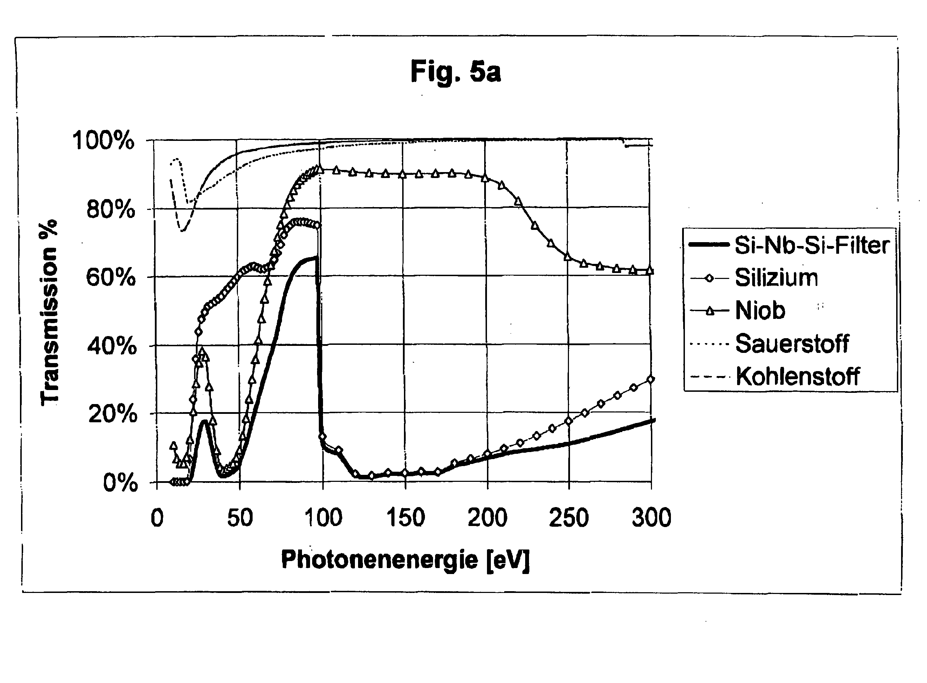

In Figur 5a ist die spektrale Charakteristik der Einzelmaterialien Silizium, Niob, Sauerstoff und Kohlenstoff in den oben angegebenen Dicken gezeigt. Außerdem ist die spektrale Charakteristik des sich daraus ergebenden Filters (Si-Nb-Si) dargestellt. Wie in Figur 5a zu erkennen ist, nimmt die Transmission von Niob ab ca. 70 eV zu kleineren Photonenenergien hin stark ab. Die Transmission von Silizium nimmt dagegen von 98 eV zu höheren Photonenenergien hin stark ab. Die Transmission der Oxidschicht ist in dem relevanten Bereich um 92 eV (entspricht 13 nm) annähernd konstant. Daß der Sauerstoff das Silizium oxidiert, hat auf die Transmission keinen Einfluß; es kommt lediglich auf die Anzahl der vorhandenen Atome an. Die Transmission der Kohlenstoffschicht ist in erster Näherung konstant gleich 1. Der spektrale Einfluß sowohl der dünnen, natürlichen Oxid- als auch Kohlenstoffschicht ist also sehr gering. Diese Schichten wirken sich aber positiv auf die Lebensdauer des optischen Filters sowohl an der Atmosphäre als auch im Vakuum unter EUV-Bestrahlung aus. Der Filter führt dazu, daß für das Energieband um 92 eV eine Transmission von mehr als 60 % vorhanden ist. Unterhalb von 50 eV und oberhalb von 100 eV liegt die Transmission deutlich unter 10 % . Erst oberhalb von 250 eV steigt die Transmission wieder auf über 10 % an. Da aber keine der heute bekannten Quellen, die für die Verwendung als Lichtquelle für die EUV-Lithographie in Frage kommen, in diesem Energiebereich nennenswerte Flüsse aufweist, ist dies von untergeordneter Bedeutung.

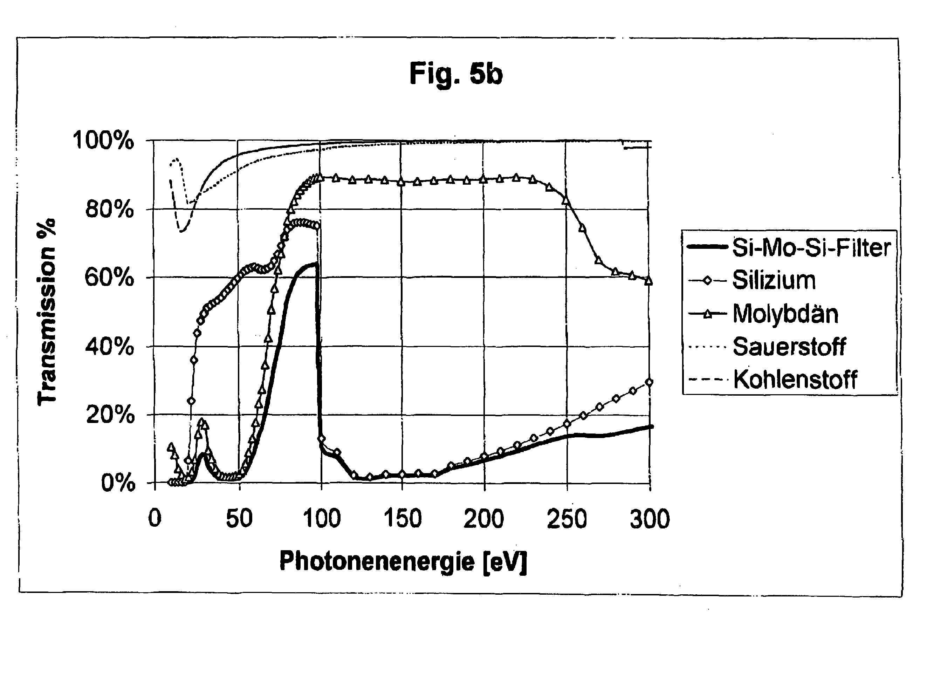

In der Figur 5b ist die spektrale Charakteristik der Einzelmaterialien Silizium, Molybdän, Sauerstoff und Kohlenstoff in den oben angegebenen Dicken hergestellt. Außerdem ist die spektrale Charakteristik des sich daraus erhebenden Filters (Si-Mo-Si) dargestellt. Wie Fig. 5b zu entnehmen ist, nimmt die Transmission von Molybdän ab ca. 70 eV zu kleineren Photonenenergien hin stark ab. Die Transmission von Silizium nimmt dagegen von 98 eV zu höheren Photonenenergien hin stark ab. Die Transmission der Oxidschicht ist in dem relevanten Bereich um 92 eV (entspricht 13 nm) annähernd konstant. Daß der Sauerstoff das Silizium oxidiert, hat auf die Transmission keinen Einfluß; es kommt lediglich auf die Anzahl der vorhandenen Atome an. Die Transmission der Kohlenstoffschicht ist in erster Näherung konstant gleich 1. Der spektrale Einfluß sowohl der dünnen, natürlichen Oxid- als auch Kohlenstoffschicht ist also sehr gering. Diese Schichten wirken sich aber positiv auf die Lebensdauer des optischen Filters sowohl an der Atmosphäre als auch im Vakuum unter EUV-Bestrahlung aus. Der Filter führt dazu, daß für das Energieband um 92 eV eine Transmission von mehr als 60 % vorhanden ist. Unterhalb von 50 eV und oberhalb von 100 eV liegt die Transmission deutlich unter 10 %. Erst oberhalb von 200 eV steigt die Transmission wieder auf über 10 % an. Da aber keine der heute bekannten Quellen, die für die Verwendung als Lichtquelle für die EUV-Lithographie in Frage kommen, in diesem Energiebereich nennenswerte Flüsse aufweist, ist dies von untergeordneter Bedeutung.

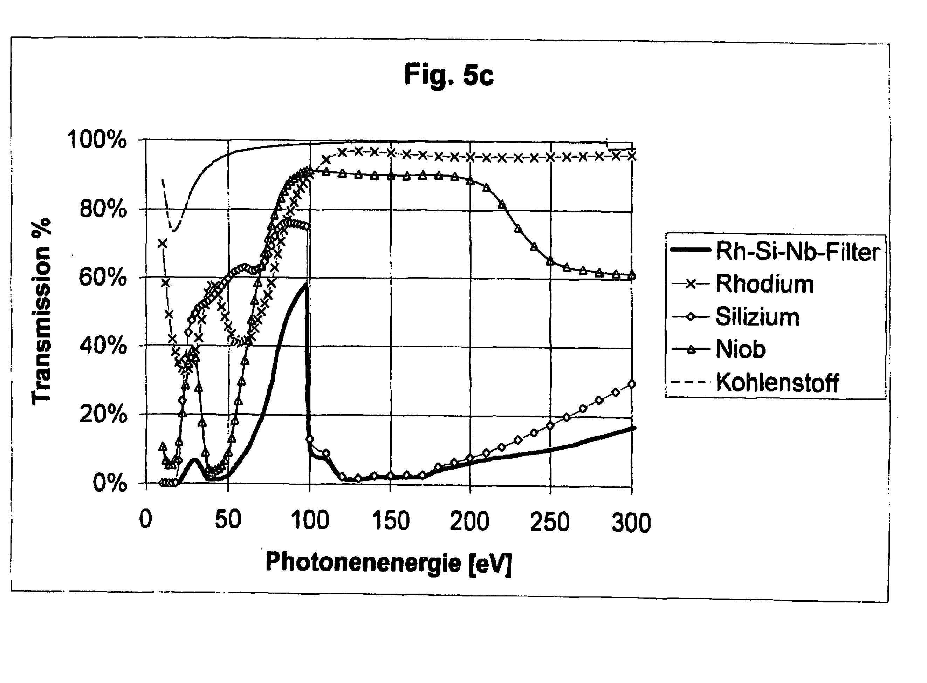

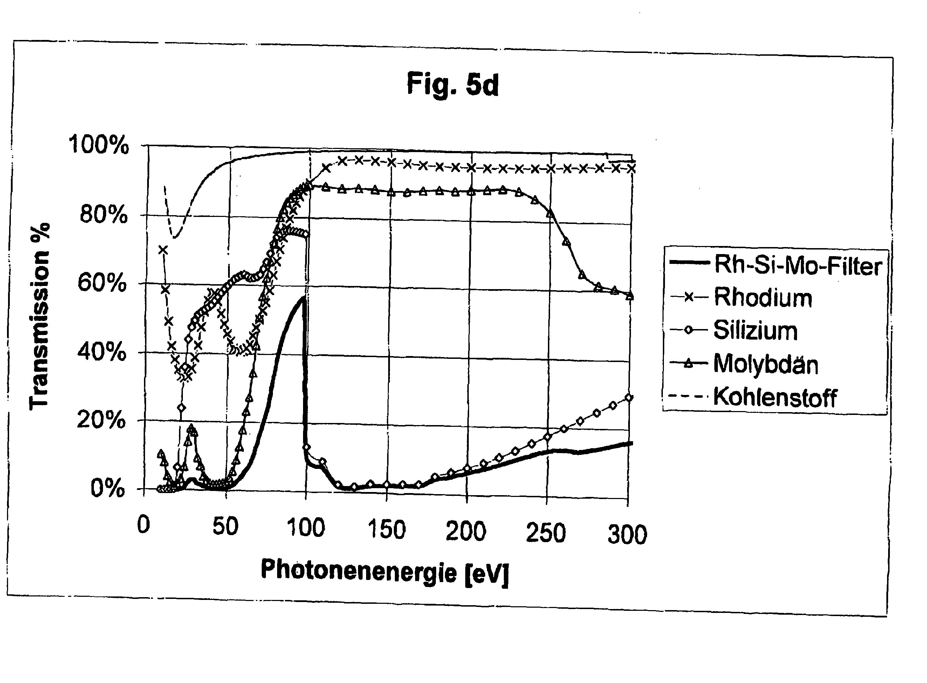

In den Figuren 5c und d ist jeweils die spektrale Charakteristik von Rhodium mit aufgetragen und außerdem die spektrale Charakteristik des sich daraus ergebenden Filter (Figur 5c: Rh-Si-Nb-Si-Rh; Figur 5d: Rh-Si-Mo-Si-Rh). Wegen der geringen Oxidation des Rhodiums bildet sich auf der Filteroberfäche nur eine Kohlenstoffschicht. Um den Preis einer reduzierten Transmission, die im Maximum etwa 55 % beträgt, erhält man eine schmalere spektrale Charakteristik. Die Transmission im Bereich zwischen 50 eV und 80 eV ist gegenüber dem Filter (Si-Nb-Si oder Si-Mo-Si) deutlich reduziert.

Die untersuchten Filter in den Figuren 1, 2 und 5 hatten folgende Schichtdicken:
- Si: je 80 nm
- Rh: je 3 nm
- Zr, Nb, Mo: 20 nm.

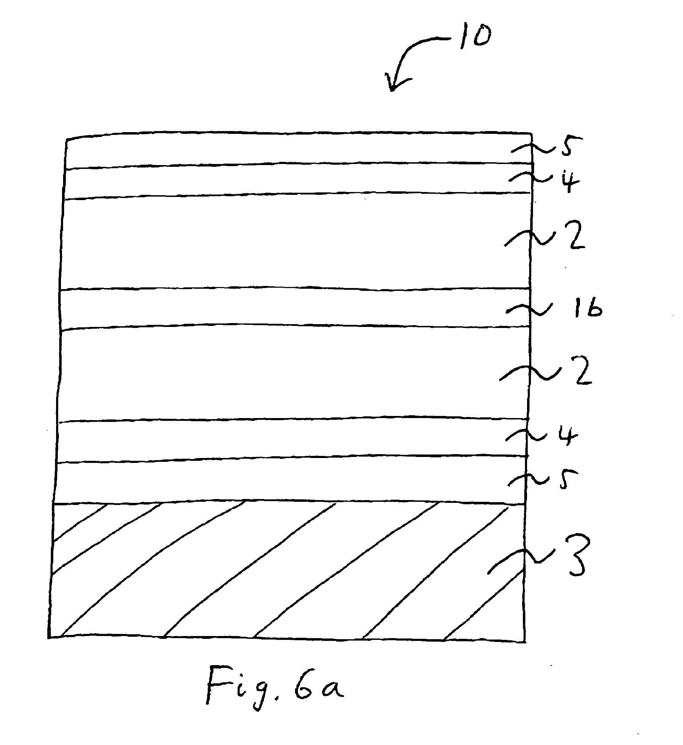

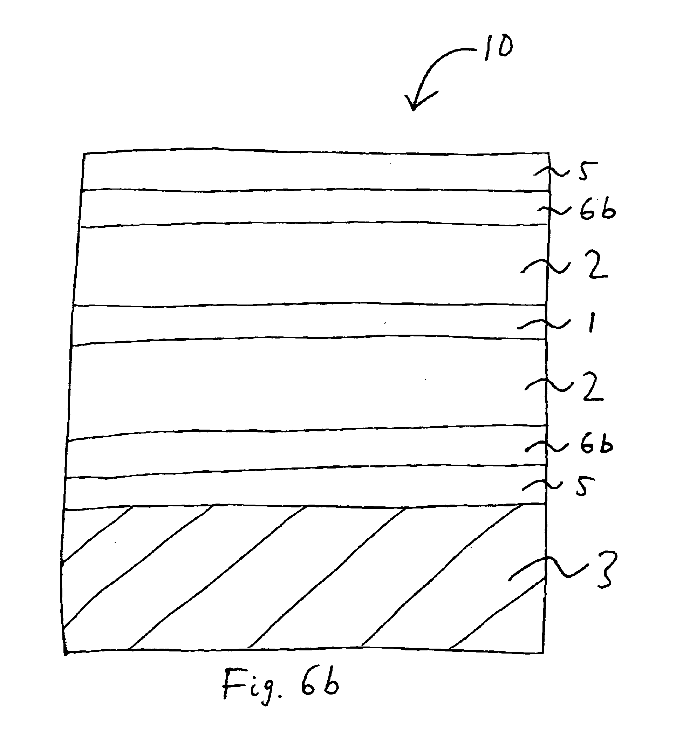

In Figur 6a ist der schematische Aufbau eines Filters 10 dargestellt. Auf beiden Seiten einer 10 bis 40 nm dicken Niobschicht 1b sind 50 nm bis 100 nm dicke Siliziumschichten 2 angeordnet. Auf beiden Seiten haben sich 1 nm bis 2 nm dicke Oxidschichten 4 und 0,5 nm bis 1,5 nm dicke kohlenstoffhaltige Schichten 5 abgelagert, die auf das Transmissionverhalten des Filters 10 keinen entscheidenden Einfluß haben. Zur mechanischen Stabilisierung ist das Gesamtsystem auf einem Nickelnetz 3 angeordnet. Anstatt einer Niobschicht kann eine Molybdänschicht 1b vorgesehen sein.

In Figur 6b ist der Aufbau eines weiteren Filters 10 dargestellt. Die Niobschicht 1b und die beiden Siliziumschichten 2 weisen auf beiden Seiten des Filters 10 jeweils eine 1 nm bis 50 nm (vorzugsweise 1 nm bis 20 nm) dicke Rhodiumschicht 6b auf, auf die sich an der Atmosphäre 0,5 nm bis 1,5 nm dicke kohlenstoffhaltige Schichten 5 ablagern. Anstelle der Rhodiumschichten 6b können auch Rutheniumschichten vorgesehen sein. Fakultativ können zwischen den Rhodiumschichten 6b und den Siliziumschichten 2 Diffusionsbarrieren, die Bor, Kohlenstoff, Stickstoff und/oder Sauerstoff enthalten, mit einer Dicke zwischen 0,1 nm bis 50 nm (vorzugsweise 1 nm bis 10 nm, insbesondere 2 nm) vorgesehen werden. Durch die Rhodiumschichten 6b werden nicht nur die mechanische Stabilität und die Lebensdauer erhöht, sondern auch die spektrale Charakteristik des Filters 10 verbessert.

Zur mechanischen und thermischen Stabilisierung ist das Gesamtsystem auf einem Nickelnetz 3 angeordnet.

Anstatt eines freistehenden Filtersystems können die Materialien auch direkt auf EUV-Komponenten aufgebracht werden. Dabei kann die Symmetrie der Schichtanordnung um die Mittelebene aufgegeben werden.

Statt einer Rhodiumschicht 6b könnte analog zu Figur 4c während des Herstellungsprozesses auch direkt auf die Siliziumschichten 2 eine Schicht 6, die Bor, Kohlenstoff, Stickstoff und/oder Sauerstoff enthält, mit einer Dicke zwischen 0,1 nm und 50 nm aufgebracht werden, auf die sich gegebenenfalls an der Atmosphäre eine weitere kohlenstoffhaltige Schicht 5 von 0,5 - 1,5 nm Dicke ablagern würde.

Aktuelle Experimente haben ergeben, daß der Einbau des beschriebenen Filters in den Strahlengang einer Synchrotron-Strahlungsquelle zu einer Erhöhung der Lebensdauer dahinter angeordneter Viellagenspiegel bis zu einem Faktor 5-10 führt.

Mit Hilfe der vorliegenden Erfindung ist es gelungen, einen schmalbandigen Spektralfilter, insbesondere für EUV-Anwendungen, bereitzustellen, der sowohl über eine geeignete spektrale Charakteristik als auch über eine hohe Lebensdauer unter Betriebsbedingungen sowie an der Atmosphäre als auch eine hohe mechanische Stabilität verfügt. Außerdem eignet es sich als Schutz vor Debris für nachfolgende optische Elemente. Wegen seiner herausragenden Eigenschaften und seiner Wirtschaftlichkeit eignet es sich insbesondere auch für den Einsatz in der Großserienlithographie mit extrem ultraviolettem Licht.

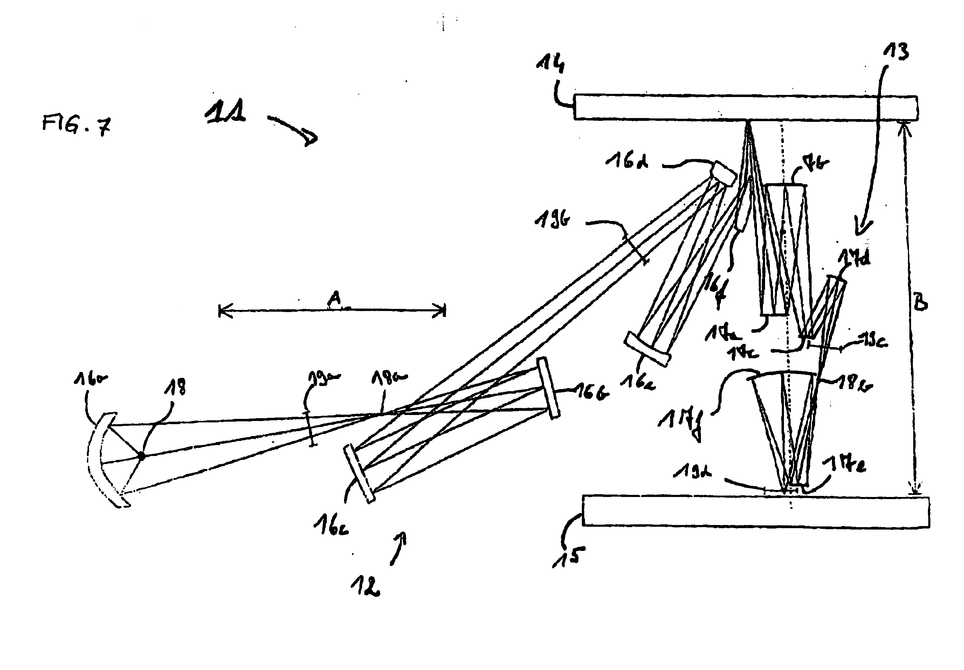

Die Figur 7 zeigt eine Projektionsbelichtungsanlage 11 mit einer Lichtquelle 18, einem Beleuchtungssystem 12, das sich aus den optischen Elementen 16a-f zusammensetzt, einem Retikel 14, einem Projektionsobjektiv 13, das sich aus den optischen Elementen 17a-17f zusammensetzt, und einen Wafer 15. Das Beleuchtungssystem 12 ist genauer in der DE 101 00 265.3 beschrieben. Das Projektionsobjektiv ist in der DE 199 48 240.3 näher beschrieben. Als Lichtquelle 18 wird eine Laser-Plasmaquelle bzw. eine Pinch-Plasmaquelle verwendet. Das Licht der Lichtquelle 18 wird von einer Kollektoreinheit, die Ellipsoidspiegel 16a ausgestaltet ist, auf eine sekundäre Lichtquelle 18a abgebildet. Danach passiert das Licht einen reflektiven Wabenkondensor aus den Spiegeln 16d und 16c. Die nachfolgende Feldlinse mit den Spiegeln 16d, 16e und 16f beleuchtet das Retikel 14 mit einem Ringfeld und paßt die Austrittspupille des Beleuchtungssystems an die Eintrittspupille des Projektionsobjektives 13 an. Das Projektionsobjektiv 13 bildet den beleuchteten Teil des Retikels 14 auf dem Wafer 15, einem mit einer lichtempfindlichen Schicht, auch Resist genannt, versehenen Substrat, ab. Dazu wird der Lichtstrahl an den Spiegeln 17a bis 17f reflektiert. Das Projektionsobjektiv 13 weist dabei eine Zwischenabbildung 18b auf. Die optische Achse des Projektionsobjektivs 13 ist durch die strichpunktierte Linie angedeutet.

Mit 19a bis d sind Positionen eingezeichnet, an denen das erfindungsgemäße Filter, angedeutet durch einen Strich mit zwei Querbalken, angeordnet werden kann. Diese Positionen sind lediglich als Beispiele zu verstehen. Sinnvollerweise sind die Filter an Stellen angeordnet, an denen der Strahlquerschnitt relativ gering ist, aber außerhalb von Strahltaillen und Brennpunkten. Der Filter kann wie z.B. an der Stelle 19a als vakuumtechnische Trennung zwischen der Strahlquelle und der Optik dienen. Er kann auch, wie beispielsweise an der Stelle 19d als vakuumtechnische Trennung zwischen der Optik und dem resistbeschichteten Wafer 15 dienen. Durch die mit A und B bezeichneten Pfeile sind die Abmessungen der Projektionsbelichtungsanlage 11 angedeutet. A beträgt 1 m, B beträgt knapp 1,50 m. Die optischen Elemente haben Durchmesser von ca. 30 cm. Üblicherweise wird man nur einen Filter im Strahlengang anordnen. Bei Filtern mit sehr guter Transmission wird man auch in Erwägung ziehen, zwei oder mehr Filter im Strahlengang anzuordnen.

In der EUV-Projektionslithographie ist es besonders vorteilhaft, nach der Strahlungsquelle Mittel zur spektralen Einengung der verwendeten EUV-Strahlung einzusetzen. Diese Mittel können Absorptionsfilter wie die zuvor beschriebenen Filter oder eine Kombination aus Beugungsgitter und einer Strahlfalle sein. Denkbar sind auch alle anderen Elemente, mit denen das Wellenlängenspektrum der Quellstrahlung auf den Nutzbereich um 92 eV eingeengt wird. Die Mittel zur spektralen Einengung sollten den Spektralbereich unter 50 eV und über 100 eV herausfiltern, bzw. die Transmission in diesen Wellenlängenbereichen vorzugsweise auf kleiner 10 % der maximalen Intensität reduzieren. Durch den Filter werden insbesondere die UV- und DUV-Strahlung nahezu vollständig herausgefiltert. Photoinduzierte Effekte, wie beispielsweise Photochemie im UV- und DUV-Wellenlängenbereich werden drastisch unterdrückt. Dies ist neben der Strahlung innerhalb des für EUV-Lithographie benötigten Spektralbereiches auch Anteile im sichtbaren Spektralbereich sowie im UV und DUV aufweisen. Durch die spektrale Einengung lassen sich Kombinationseffekte auf den Spiegeloberflächen der nachfolgenden Elemente der Projektionsbelichtungsanlage durch photoinduzierte Prozesse deutlich reduzieren.

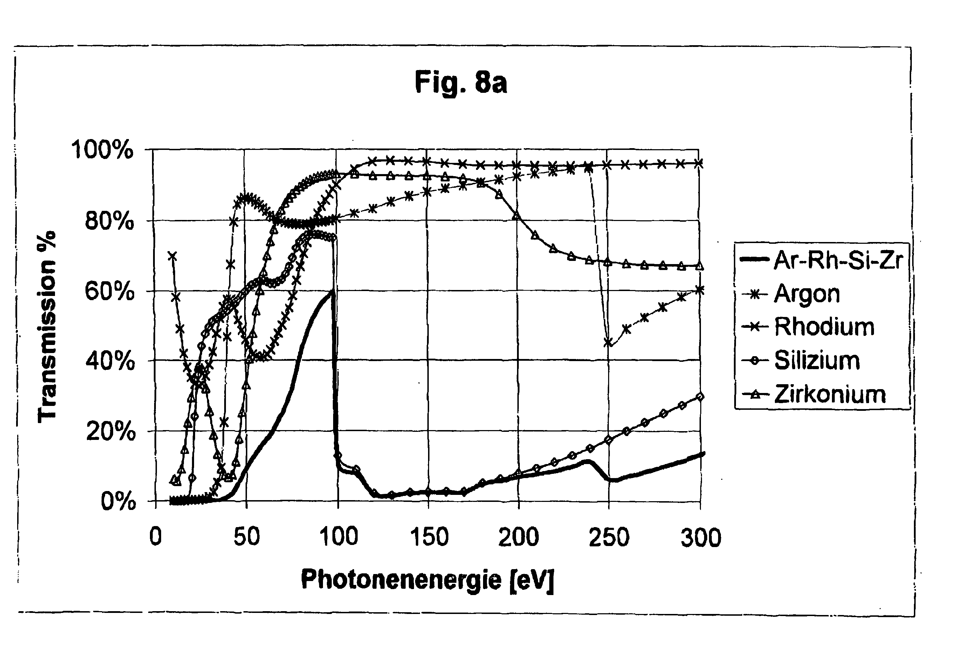

In den Figuren 8a-d sind weitere Filterbeispiele dargestellt, die folgende Schichtenfolgen aufweisen:
- Fig. 8a:: Ar(1m bei 0,05 mbar)/Rh(3 nm)/Si(80 nm)/Zr(20 nm)/Si(80 nm)/Rh(3 nm)/Ar(1 m bei 0,05 mbar)

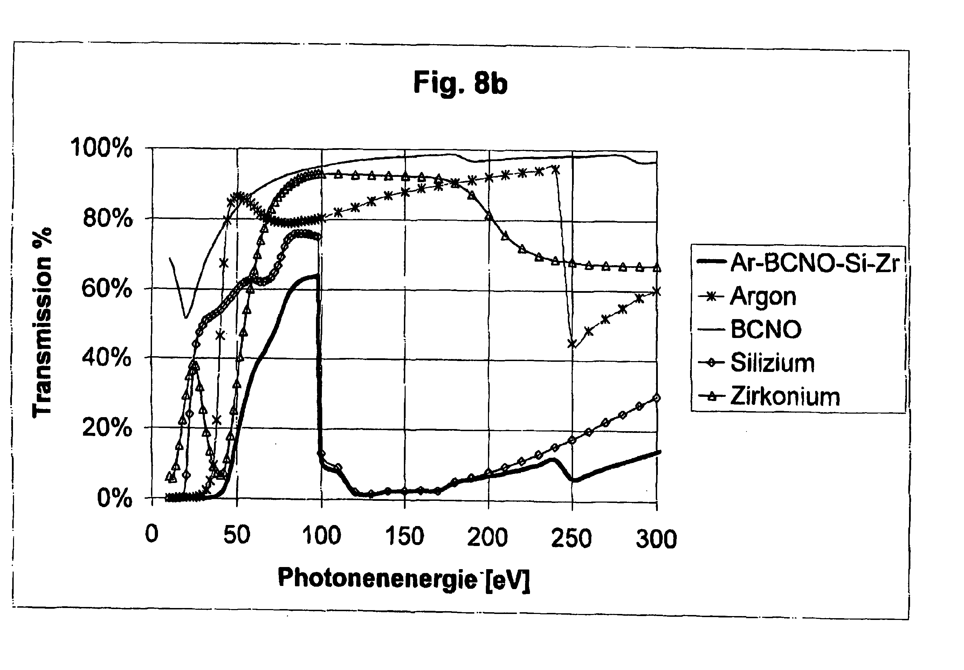

- Fig. 8b:: Ar(1 m bei 0,05 mbar)/"BCNO"(3 nm)/Si(80 nm)/Zr(20 nm)/Si(80 nm)/"BCNO"(3 nm)/Ar(1 m bei 0,05 mbar)

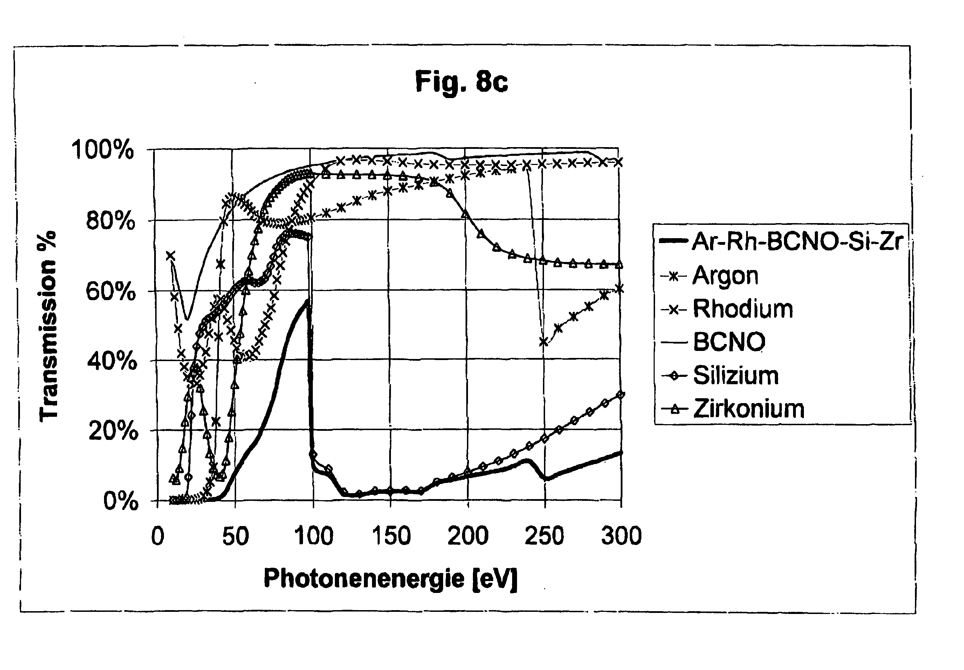

- Fig. 8c:: Ar(1 m bei 0,05 mbar)/Rh(3 nm)/"BCNO" 3nm)/Si(80 nm)/Zr(20 nm)/Si(80 nm)/"BCNO"(3 nm)/Rh(2 nm)/Ar(1 m bei 0,05 mbar)

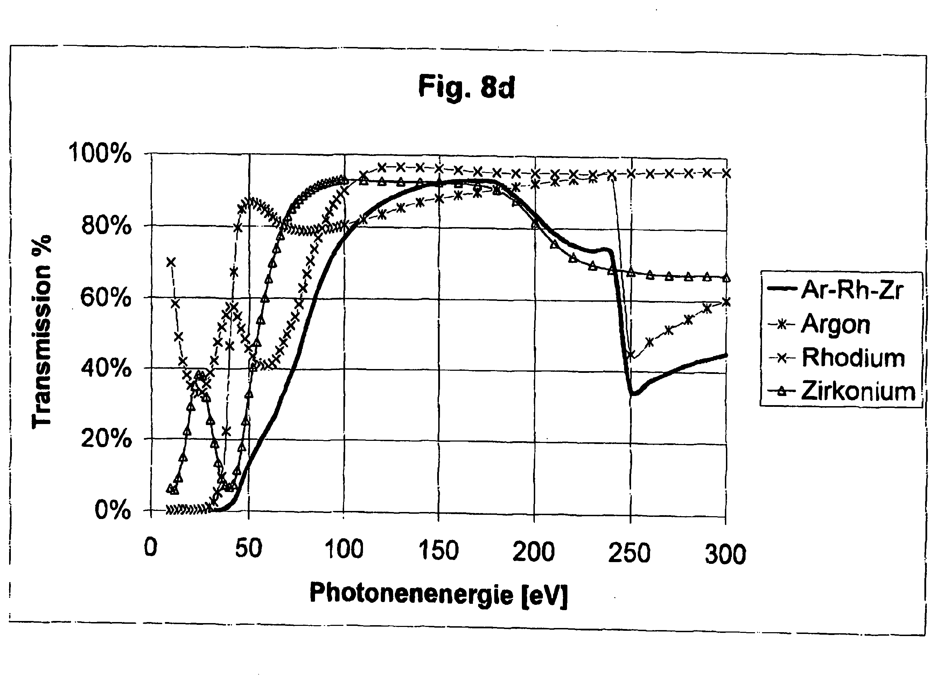

- Fig. 8d:: Ar(1 m bei 0,05 mbar)/Rh(3 nm)/Zr(20 nm)/Rh(3 nm)/Ar(1 m bei 0,05 mbar).

In allen Fällen ist vorgesehen, daß sich vor und hinter dem Filter eine 1 m dicke Gasschicht aus Argon mit einem Druck von 0,05 mbar befindet, die ebenfalls zur Filterung beiträgt.

Das in Figur 8d gezeigte Beispiel wird vorzugsweise in Verbindung mit EUV-Quellen eingesetzt, die ohnehin keine Strahlung oberhalb 100 eV abgeben. Strahlung mit derartiger Charakteristik kann auch durch eine Vorfilterung der Strahlung mit Si-haltigen Filtern erreicht werden. Der Vorteil dieses Filters liegt dann in einer höheren Transmission im Bereich um 92 eV mit weiterhin starker Unterdrückung unterhalb 80 eV.

## Patentansprüche

1. Optischer Filter für den extremen ultravioletten Wellenlängenbereich, mit mindestens zwei Siliziumschichten (2), zwischen denen mindestens eine Zirkoniumschicht (1a) angeordnet ist.

2. Optischer Filter nach Anspruch 1, **dadurch gekennzeichnet, daß** er mindestens aus einer zwischen zwei Siliziumschichten (2) angeordneten Zirkoniumschicht (1a) besteht, wobei die Siliziumschichten (2) dicker als die Zirkoniumschicht (1a) sind.

3. Optischer Filter nach einem der Ansprüche 1 oder 2, **dadurch gekennzeichnet, daß** für die Dicke dZr der Zirkoniumschicht (1a) 1 nm ≤ dZr ≤ 1000 nm gilt und die Dicke der Siliziumschichten (2) dSi = 1-e^{-k.dZr} in µm mit 0,001 ≤ k ≤ 0,005 in 1/nm ist.

4. Optischer Filter nach einem der Ansprüche 1 bis 3, **dadurch gekennzeichnet, daß** die Siliziumschichten (2) eine Dicke zwischen 50 nm und 100 nm aufweisen und die Zirkoniumschicht (1a) eine Dicke zwischen 10 nm und 40 nm aufweist.

5. Optischer Filter für den extrem ultravioletten Wellenlängenbereich, mit mindestens zwei Siliziumschichten (2), zwischen denen mindestens eine Niobschicht (1 b) angeordnet ist.

6. Transmissionsfilter für den extrem ultravioletten Wellenlängenbereich, mit nicht mehr als zwei Siliziumschichten (2), zwischen denen mindestens eine Molybdänschicht (1b) angeordnet ist.

7. Filter nach Anspruch 5 oder 6, **dadurch gekennzeichnet, daß** die Siliziumschichten dicker als die Niob- oder die Molybdänschicht (1b) sind.

8. Filter nach einem der Ansprüche 5 bis 7, **dadurch gekennzeichnet, daß** für die Dicke dNb der Niobschicht (1b) 1 nm < dNb < 1000 nm gilt und die Dicke der Siliziumschichten (2) dSi = 1-e^{-k.dNb} in µm mit 0,001 < k < 0,005 in 1/nm ist.

9. Filter nach einem der Ansprüche 5 bis 7, **dadurch gekennzeichnet, daß** für die Dicke dMo der Molybdänschicht (1b) 1 nm < dMo < 1000 nm gilt und die Dicke der Siliziumschichten (2) dSi = 1-e^{-k.dMo} in µm mit 0,001 < k < 0,005 in 1/nm ist.

10. Filter nach einem der Ansprüche 5 bis 9, **dadurch gekennzeichnet, daß** die Siliziumschichten (2) eine Dicke zwischen 50 nm und 100 nm aufweisen und die Niob- bzw. Molybdänschicht (1b) eine Dicke zwischen 10 nm und 40 nm aufweist.

11. Filter nach einem der Ansprüche 1 bis 10, **dadurch gekennzeichnet, daß** die mindestens drei Schichten (1a, b, 2) selbsttragend sind.

12. Filter nach einem der Ansprüche 1 bis 11, **dadurch gekennzeichnet, daß** er in der Filterebene eine maximale Abmessung zwischen 1 cm und 4 cm aufweist.

13. Filter nach einem der Ansprüche 1 bis 12, **dadurch gekennzeichnet, daß** die mindestens drei Schichten (1a, b, 2) auf einer Stützstruktur (3) aufgebracht sind.

14. Filter nach einem der Ansprüche 1 bis 13, **dadurch gekennzeichnet, daß** zwischen zwei oder innerhalb einer der mindestens drei Schichten (1a, b, 2) eine Stützstruktur (3) angeordnet ist.

15. Filter nach Anspruch 13 oder 14, **dadurch gekennzeichnet, daß** es sich bei der Stützstruktur (3) um ein Nickelnetz handelt.

16. Filter nach einem der Ansprüche 13 bis 15, **dadurch gekennzeichnet, daß** er in der Filterebene eine maximale Abmessung zwischen 8 cm und 14 cm aufweist.

17. Filter nach einem der Ansprüche 1 bis 16, **dadurch gekennzeichnet, daß** sich auf mindestens einer Seite des Filters mindestens eine weitere Schicht (4, 5) mit Schutzfunktion befindet.

18. Filter nach einem der Ansprüche 1 bis 17, **dadurch gekennzeichnet, daß** er auf mindestens einer Seite eine Rutheniumschicht (6a) aufweist.

19. Filter nach einem der Ansprüche 1 bis 17, **dadurch gekennzeichnet, daß** er auf mindestens einer Seite eine Rhodiumschicht (6b) aufweist.

20. Filter nach einem der Ansprüche 18 oder 19, **dadurch gekennzeichnet, daß** die Ruthenium- bzw. Rhodiumschicht (6a, 6b) eine Dicke zwischen 0,1 nm und 50 nm aufweist.

21. Filter nach einem der Ansprüche 1 bis 20, **dadurch gekennzeichnet, daß** er auf mindestens einer Seite eine Schicht (6c), die Bor, Kohlenstoff, Stickstoff und/oder Sauerstoff enthält, aufweist.

22. Filter nach Anspruch 21, **dadurch gekennzeichnet, daß** die Schicht (6c), die Bor, Kohlenstoff, Stickstoff und/oder Sauerstoff enthält, eine Dicke zwischen 0,1 nm und 50 nm aufweist.

23. Filter nach einem der Ansprüche 17 bis 22, **dadurch gekennzeichnet, daß** er zwischen einer außenliegenden Schicht (4, 5, 6a-c) und der Siliziumschicht (2) als Diffusionsbarriere eine Schicht aufweist, die Bor, Kohlenstoff, Stickstoff und/oder Sauerstoff in einer Verbindung einzeln oder in Kombination enthält.

24. Filter nach Anspruch 23, **dadurch gekennzeichnet, daß** die Diffusionsbarriere-Schicht eine Dicke zwischen 0,1 nm und 50 nm aufweist.

25. Verwendung eines optischen Filters bzw. Transmissionsfilters nach einem der Ansprüche 1 bis 24 in einem Beleuchtungssystem für extrem ultraviolettes Licht.

26. Verwendung eines optischen Filters bzw. Transmissionsfilters nach einem der Ansprüche 1 bis 24 in einer Projektionsbelichtungsanlage für extrem ultraviolettes Licht.

27. Optische Vorrichtung mit einem Strahlengang für den EUV-Wellenlängenbereich, wobei der Strahlengang mindestens einen Filter gemäß der Ansprüche 1 bis 24 aufweist.

28. Optische Vorrichtung nach Anspruch 27, wobei die Vorrichtung ein Lithographiegerät für die Halbleiterbauteilproduktion ist.

29. Optische Vorrichtung nach Anspruch 27 oder 28, **dadurch gekennzeichnet, daß** mindestens der Filter sich in einer Gas-Atmosphäre mit einem Druck von 10⁻² bis 10⁻⁸ mbar befindet.

30. Optische Vorrichtung nach Anspruch 29, wobei die Gas-Atmosphäre eine Argon-Atmosphäre ist.

## Claims

1. Optical filter for the extreme ultraviolet wave length range with at least two silicon layers (2), between which is arranged at least one zirconium layer (1a).

2. Optical filter according to claim 1, **characterized in that** it consists of at least one zirconium layer (1a) arranged between two silicon layers (2), whereby the silicon layers (2) are thicker than the zirconium layer(1a).

3. Optical filter according to claims 1 or 2, **characterized in that** the thickness dZr of the zirconium layer (1a) is 1 nm ≤ dZr ≤ 1000nm, and that the thickness dSi of the silicon layers(2) is dSi =1-e^{-k.dZr} in µm with 0,001 ≤ k ≤ 0,005 in 1/nm.

4. Optical filter according to one of the claims 1 through 3, **characterized in that** the silicon layers (2) exhibit a thickness between 50 nm and 100 nm, and the zirconium layer (1a) exhibits a thickness between 10 nm and 40 nm.

5. Optical filter for the extreme ultraviolet wavelength range with at least two silicon layers (2), between which at least one niobium layer (1b) is arranged.

6. Transmission filter for the extreme ultraviolet wavelength range with not more than two silicon layers (2), between which at least one molybdenum layer (1b) is arranged.

7. Filter according to one of the claims 5 or 6, **characterized in that** the silicon layers are thicker than the niobium layer or the molybdenum layer (1b).

8. Filter according to one of the claims 5 through 7, **characterized in that** the thickness dNb of the niobium layer (1b) is 1 nm < dNb < 1000 nm, and that the thickness dSi of the silicon layers (2) is dSi=1-e^{-k.dNb} in µm with 0,001 ≤ k ≤ 0,005 in 1/nm.

9. Filter according to one of the claims 5 through 7, **characterized in that** the thickness dMo of the molybdenum layer (1b) is 1 nm < dMo < 1000 nm, and the thickness dSi of the silicon layers(2) is dSi=1-e^{-k.dMo} in µm with 0,001 < k < 0,005 in 1/nm.

10. Filter according to one of the claims 5 through 9, **characterized in that** the silicon layers (2) exhibit a thickness between 50nm and 100nm, and the niobium layer and the molybdenum layer (1b) respectively exhibits a thickness between 10 nm and 40 nm.

11. Filter according to one of the claims 1 through 10, **characterized in that** the at least three layers (1a,b,2) are self-supporting.

12. Filter according to one of the claims 1 through 11, **characterized in that** it has a maximum size between 1 cm and 4 cm in the filter plane.

13. Filter according to one of the claims 1 through 12, **characterized in that** the at least three layers (1a, b, 2)are applied onto a support structure(3).

14. Filter according to one of the claims 1 through 13, **characterized in that** a support structure (3) is arranged between two or within one of the at least three layers (1a,b,2).

15. Filter according to one of the claims 13 or 14, **characterized in that** the support structure (3) is a nickel mesh.

16. Filter according to one of the claims 13 through 15, **characterized in that** it has a maximum size between 8 cm und 14 cm in the filter plane.

17. Filter according to one of the claims 1 through 16, **characterized in that** there is at least one further layer (4,5) having a protective function on at least one side of the filter.

18. Filter according to one of the claims 1 through 17, **characterized in that** it exhibits a ruthenium layer (6a) on at least one side.

19. Filter according to one of the claims 1 through 17, **characterized in that** it exhibits a rhodium layer (6b) on at least one side.

20. Filter according to one of the claims 18 or 19, **characterized in that** the ruthenium layer and the rhodium layer (6a, 6b) respectively exhibits a thickness between 0.1 nm and 50nm.

21. Filter according to one of the claims 1 through 20, **characterized in that** it comprises on at least one side a layer (6c) which contains boron, carbon, nitrogen and/or oxygen.

22. Filter according to claim 21, **characterized in that** the layer (6c) containing boron, carbon, nitrogen and/or oxygen exhibits a thickness between 0.1 nm and 50 nm.

23. Filter according to one of the claims 17 to 22, **characterized in that** it exhibits between an external layer (4,5,6a-c)and the silicon layer (2) as a diffusion barrier a layer which contains boron, carbon, nitrogen and/or oxygen in a compound as an individual or in combination.

24. Filter according to claim 23, **characterized in that** the diffusion barrier layer exhibits a thickness between 0.1 nm and 50 nm.

25. Use of an optical filter and of a transmission filter respectively according to one of the claims 1 to 24 in a lighting system for extreme ultraviolet light.

26. Use of an optical filter and of a transmission filter respectively according to one of the claims 1 to 24 in a light projection device for extreme ultra violet light.

27. Optical apparatus with an optical path for the EUV wavelength range, in which the optical path comprises at least one filter according to claims 1 through 24.

28. Optical apparatus according to claim 27, in which there is a lithographic device for semiconductor component production.

29. Optical apparatus according to one of the claim 27 or 28, **characterized in that** at least the filter is arranged in a gas atmosphere having a pressure of 10⁻² to 10⁻⁸ mbar.

30. Optical apparatus according to claim 29, in which the gas atmosphere is an argon atmosphere.

## Revendications

1. Filtre optique pour un domaine de longueurs d'onde d'extrême ultraviolet, avec au moins deux couches de silicium (2), entre lesquelles est disposée au moins une couche de zirconium (1a).

2. Filtre optique selon la revendication 1, **caractérisé en ce qu'**il consiste au moins en une couche de zirconium (1a) disposée entre deux couches de silicium (2), les couches de silicium (2) étant plus épaisses que la couche de zirconium (1a).

3. Filtre optique selon l'une des revendications 1 ou 2, **caractérisé en ce que** 1nm≤dZr≤1000nm correspond à l'épaisseur dZr de la couche de zirconium (1a), et que l'épaisseur des couches de silicium (2) dSi=1-e^{-k.dZr} en µm, avec 0,001≤k≤0,005 en 1/nm.

4. Filtre optique selon l'une des revendications 1 à 3, **caractérisé en ce que** les couches de silicium (2) présentent une épaisseur entre 50nm et 100nm, et la couche de zirconium (1a) présente une épaisseur entre 10nm et 40nm.

5. Filtre optique pour un domaine de longueurs d'onde d'extrême ultraviolet, avec au moins deux couches de silicium (2), entre lesquelles est disposée au moins une couche de niobium (1b).

6. Filtre de transmission pour un domaine de longueurs d'onde d'extrême ultraviolet, avec pas plus de deux couches de silicium (2) entre lesquelles est disposée au moins une couche de molybdène (1b).

7. Filtre selon la revendication 5 ou 6, **caractérisé en ce que** les couches de silicium sont plus épaisses que la couche de niobium ou de molybdène (1b).

8. Filtre selon l'une des revendications 5 à 7, **caractérisé en ce que** l'épaisseur dNb de la couche de niobium (1b) correspond à 1nm<dNb<1000nm, et que l'épaisseur des couches de silicium (2) dSi=1-e^{-k.dNb} en µm, avec 0,001≤k≤0,005 en 1/nm.

9. Filtre selon l'une des revendications 5 à 7, **caractérisé en ce que** l'épaisseur dMo de la couche de molybdène (1b) correspond à 1nm<dMo<1000nm, et que l'épaisseur des couches de silicium (2) dSi=1-e^{-k.dMo} en µm, avec 0,001<k<0,005 en 1/nm.

10. Filtre optique selon l'une des revendications 5 à 9, **caractérisé en ce que** les couches de silicium (2) présentent une épaisseur entre 50nm et 100nm, et l'épaisseur de la couche de niobium et de molybdène (1b) présente une épaisseur entre 10nm et 40nm.

11. Filtre selon l'une des revendications 1 à 10, **caractérisé en ce que** les au moins trois couches (1a, b, 2) sont autoporteuses.

12. Filtre selon l'une des revendications 1 à 11, **caractérisé en ce qu'**il présente dans le plan du filtre une dimension maximale entre 1cm et 4cm.

13. Filtre selon l'une des revendications 1 à 12, **caractérisé en ce que** les au moins trois couches (1a, b, 2) sont placées sur une structure d'appui (3).

14. Filtre selon l'une des revendications 1 à 13, **caractérisé en ce qu'**une structure d'appui (3) est disposée entre deux ou à l'intérieur d'une des au moins trois couches (1a, b, 2).

15. Filtre selon la revendication 13 ou 14, **caractérisé en ce que** la structure d'appui (3) se compose d'un maillage en nickel.

16. Filtre selon l'une des revendications 13 à 15, **caractérisé en ce qu'**il présente dans le plan du filtre une épaisseur maximale entre 8cm et 14cm.

17. Filtre selon l'une des revendications 1 à 16, **caractérisé en ce qu'**il se trouve sur au moins un côté du filtre au moins une couche supplémentaire (4, 5) à des fins de protection.

18. Filtre selon l'une des revendications 1 à 17, **caractérisé en ce qu'**il présente sur au moins un côté une couche de ruthénium (6a).

19. Filtre selon l'une des revendications 1 à 17, **caractérisé en ce qu'**il présente sur au moins un côté une couche de rhodium (6a).

20. Filtre selon l'une des revendications 18 ou 19, **caractérisé en ce que** la couche de ruthénium et de rhodium (6a, 6b) présente une épaisseur entre 0,1nm et 50nm.

21. Filtre selon l'une des revendications 1 à 20, **caractérisé en ce qu'**il présente sur au moins un côté une couche (6c), qui contient du bore, du carbone, de l'azote et/ou de l'oxygène.

22. Filtre selon la revendication 21, **caractérisé en ce que** la couche (6c), qui contient du bore, du carbone, de l'azote et/ou de l'oxygène, présente une épaisseur entre 0,1nm et 50nm.

23. Filtre selon l'une des revendications 17 à 22, **caractérisé en ce qu'**il présente entre une couche extérieure (4, 5, 6a-c) et la couche de silicium (2), une couche en tant que barrière de diffusion, qui contient du bore, du carbone, de l'azote et/ou de l'oxygène isolément dans un composé ou en combinaison.

24. Filtre selon la revendication 23, **caractérisé en ce que** la couche barrière de diffusion présente une épaisseur entre 0,1nm et 50nm.

25. Utilisation d'un filtre optique et d'un filtre de transmission selon l'une des revendications 1 à 24 dans un système d'éclairage à lumière d'extrême ultraviolet.

26. Utilisation d'un filtre optique et d'un filtre de transmission selon l'une des revendications 1 à 24, dans un dispositif d'éclairage de projection à lumière d'extrême ultraviolet.

27. Dispositif optique avec parcours optique pour un domaine de longueurs d'onde EUV, dont le parcours optique présente au moins un filtre selon les revendications 1 à 24.

28. Dispositif optique selon la spécification 27 dont le dispositif est un appareil lithographique de production d'éléments semiconducteurs.

29. Dispositif optique selon la revendication 27 ou 28, **caractérisé en ce qu'**au moins un filtre se situe dans une atmosphère gazeuse avec une pression de 10⁻² à 10⁻⁸mbar.

30. Dispositif optique selon la revendication 29, dont l'atmosphère gazeuse est une atmosphère d'argon.
